# EUROPEAN PATENT APPLICATION

(11) **EP 4 561 319 A1**
(43) Date of publication of application: **28.05.2025**
(21) Application number: 24214799.9
(22) Date of filing: 22.11.2024
(51) Int. Cl.: H10K 59/122, H10K 59/123, H10K 59/80

(54) **DISPLAY DEVICE**

(30) Priority: 24.11.2023 KR 20230165042
(71) Applicant: Samsung Display Co., Ltd., Yongin-si, Gyeonggi-do 17113 (KR)
(72) Inventor: PARK, Juchan, 17113 Yongin-si (KR); KO, Yoomin, 17113 Yongin-si (KR); KIM, Sunho, 17113 Yongin-si (KR); KIM, Hyewon, 17113 Yongin-si (KR); SON, Yerim, 17113 Yongin-si (KR); LEE, Pilsuk, 17113 Yongin-si (KR); CHOI, Chung Sock, 17113 Yongin-si (KR); HONG, Sungjin, 17113 Yongin-si (KR)
(74) Representative: Walaski, Jan Filip

(57) **Abstract**

A display device includes a base layer, a driving element layer including a transistor, insulating layers, and a driving connection part electrically connected to the transistor, a light emitting element layer including a pixel defining layer in which a light emitting opening and a through-hole that does not overlap the light emitting opening are defined, a light emitting element located in the light emitting opening, and a separator located on the pixel defining layer, and a conductive pattern located below the separator and including a contact part in the through-hole, and an extension part connected to the contact part and located on a top surface of the pixel defining layer. The light emitting element includes an anode on the driving element layer, an intermediate layer on the anode, and a cathode on the intermediate layer, and the contact part is electrically connected to the driving connection part.

## Description

### CROSS-REFERENCE TO RELATED APPLICATIONS

The present application claims priority to Korean Patent Application No. 10-2023-0165042, filed on November 24, 2023.

### BACKGROUND

### 1. Field

The present disclosure relates to a display device, and more specifically, to a display device having improved resolution.

### 2. Description of the Related Art

Multimedia electronic apparatuses such as televisions, mobile phones, tablet computers, navigators, game consoles, and/or the like includes a display device for displaying an image.

The display device includes a light emitting element and a circuit for driving the light emitting element. Such a light emitting element provided in the display device emit light according to a voltage applied from the circuit to generate an image. To improve reliability of the display device, research on connection between the light emitting element and the circuit is being conducted. In addition, to improve resolution of the display device, an arrangement of a contact part for connection between the light emitting element and the circuit may be considered.

### SUMMARY

One or more embodiments of the present disclosure provides a display device having improved resolution characteristics.

One or more embodiments of the present disclosure provide a display device including: a base layer; a driving element layer on the base layer and including a transistor, a plurality of insulating layer on the transistor, and a driving connection part electrically connected to the transistor; a light emitting element layer on the driving element layer and including a pixel defining layer, in which a light emitting opening and a through-hole that does not overlap the light emitting opening are defined, a light emitting element located in the light emitting opening, and a separator located on the pixel defining layer; and a conductive pattern below the separator and including a contact part in the through-hole, and an extension part connected to the contact part and on a top surface of the pixel defining layer, wherein the light emitting element includes an anode on the driving element layer, an intermediate layer on the anode, and a cathode on the intermediate layer, and the contact part is electrically connected to the driving connection part, and the extension part is connected to the cathode on the top surface of the pixel defining layer.

In one or more embodiments, in a plan view, the through-hole may be spaced from an edge of the separator and overlaps the separator.

In one or more embodiments, one side surface of the extension part adjacent to the light emitting opening on the pixel defining layer may be exposed from the separator, and the cathode may be connected to the exposed one side surface of the extension part.

In one or more embodiments, the cathode and the intermediate layer may be disconnected by the separator, and a first end of the disconnected intermediate layer may be connected to the one side surface on the pixel defining layer, and a first end of the disconnected cathode may be connected to the one side surface on the intermediate layer.

In one or more embodiments, the first end of the intermediate layer and the first end of the cathode may not overlap the separator in a plan view.

In one or more embodiments, the first end of the intermediate layer and the first end of the cathode may overlap the separator in a plan view.

In one or more embodiments, a second end of the disconnected intermediate layer may be on the separator, and a second end of the disconnected cathode may be located on the intermediate layer on the separator.

In one or more embodiments, the extension part may have a thickness of about 1,000 Å or more and about 5,000 Å or less.

In one or more embodiments, one end of the extension part adjacent to the light emitting opening on the pixel defining layer may be exposed from the separator, and the cathode may be connected to an exposed top surface of the one end of the extension part.

In one or more embodiments, the cathode and the intermediate layer may be disconnected by the separator, a first end of the disconnected intermediate layer is directly located on the exposed top surface, and a first end of the disconnected cathode may be configured to cover the intermediate layer on the exposed top surface and is contacted to the exposed top surface.

In one or more embodiments, the first end of the intermediate layer and the first end of the cathode may overlap the separator in a plan view.

In one or more embodiments, the first end of the intermediate layer and the first end of the cathode may not overlap the separator in a plan view.

In one or more embodiments, a second end of the disconnected intermediate layer may be on the separator, and a second end of the disconnected cathode may be on the intermediate layer on the separator.

In one or more embodiments, the extension part may have a thickness of about 500 Å or less.

In one or more embodiments, the separator may include: a lower pattern adjacent to the pixel defining layer; and an upper pattern continuously located on the lower pattern and having a width greater than that of the lower pattern in a cross-section, wherein, in the cross-section, a side surface of the separator may include an inflection portion between the lower pattern and the upper pattern.

In one or more embodiments, the conductive pattern may include a transparent conductive metal material.

In one or more embodiments, the driving connection part may include a first layer including titanium, a second layer on the first layer and including aluminum, and a third layer on the second layer and including titanium, which are sequentially laminated.

In one or more embodiments, the transistor may include a semiconductor pattern including a source region, a drain region, and a channel region located between the source region and the drain region, and the conductive pattern may be electrically connected to the drain region through the driving connection part.

In one or more embodiments, the transistor may include an N-type transistor.

In one or more embodiments of the inventive concept, a display device includes: a base layer; a transistor on the base layer; a lower insulating layer on the transistor and having a lower hole; a driving connection part in the lower hole, on the lower insulating layer, and electrically connected to the transistor; an upper insulating layer covering the driving connection part on the lower insulating layer; a pixel defining layer on the upper insulating layer and having a light emitting opening; a separator not overlapping the light emitting opening on the pixel defining layer; a conductive pattern passing through the upper insulating layer and the pixel defining layer and in a through-hole overlapping the separator; and a light emitting element on the upper insulating layer and including a light emitting layer on the light emitting opening, a first electrode located below the light emitting layer, a second electrode on the light emitting layer, and a functional layer on at least one of between the first electrode and the light emitting layer or between the light emitting layer and the second electrode, wherein one end of the conductive pattern is connected to the driving connection part, and an other end of the conductive pattern is connected to the second electrode on the pixel defining layer.

In one or more embodiments, the conductive pattern may include: a contact part in the through-hole and including the one end of the conductive pattern; and an extension part connected to the contact part, including the other end of the conductive pattern, and located on a top surface of the pixel defining layer.

In one or more embodiments, the second electrode extending from the light emitting opening in a direction of the separator and the functional layer may be disconnected by the separator, the disconnected second electrode and a first portion that is one end of the functional layer may be connected to the other end of the conductive pattern, and the disconnected second electrode and a second portion that is an other end of the functional layer may be disposed on the separator.

In one or more embodiments, each of the first portion and the second portion may be on the functional layer.

In one or more embodiments, the first portion may be directly on a side surface or a top surface of the other end of the conductive pattern.

In one or more embodiments, the first portion may include the functional layer directly located on a top surface of the conductive pattern and the second electrode directly located on the functional layer, and an edge of the second electrode may be further adjacent to the through-hole in a plan view than an edge of the functional layer.

In one or more embodiments, the transistor may include a semiconductor pattern including a source region, a drain region, and a channel region between the source region and the drain region, and the conductive pattern may be electrically connected to the drain region and the second electrode through the driving connection part.

In one or more embodiments, a display device including a plurality of light emitting parts configured to emit light having different wavelength ranges, includes: a separator separating the light emitting parts from each other; a pixel defining layer located below the separator and having a light emitting opening, the plurality of light emitting parts being located in the light emitting opening, respectively, and a through-hole, the through-hole not overlapping the light emitting opening; a light emitting element corresponding to each of the light emitting parts and including an anode, an intermediate layer located on the anode, and a cathode located on the intermediate layer; a driving element layer below the pixel defining layer and including a transistor; and a conductive pattern in the through-hole, electrically connecting the cathode to the transistor, and located below the separator.

In one or more embodiments, in a plan view, the through-hole may overlap the separator.

In one or more embodiments, in a plan view, the conductive pattern may be in a form of a closed line that is around each of the plurality of light emitting parts along a shape of the separator.

In one or more embodiments, the plurality of light emitting parts may include a first light emitting part, a second light emitting part, and a third light emitting part, spaced from each other in a plan view, the conductive pattern comprises a first conductive pattern around the first light emitting part, a second conductive pattern around the second light emitting part, and a third conductive pattern around the third light emitting part, and each of the first conductive pattern, the second conductive pattern, and the third conductive pattern may be in a form of a closed line.

In one or more embodiments, the conductive pattern may include a contact part in the through-hole and an extension part connected to the contact part and located between the pixel defining layer and the separator, and the extension part and the cathode may be connected to each other.

In one or more embodiments, the cathode may be directly located on a side surface or top surface of the extension part.

In one or more embodiments, as a distance between the light emitting parts adjacent to each other increases, a thickness of the intermediate layer adjacent to the conductive pattern may decrease.

In one or more embodiments, the cathode may be connected to a top surface of the conductive pattern exposed below the separator, and as a distance between the light emitting parts adjacent to each other increases, a contact area of the cathode on a top surface of the conductive pattern may increase.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a block diagram of a display device;
FIGS. 2A and 2B are equivalent circuit diagrams of a pixel;
FIGS. 3A and 3B are plan views of a display panel;
FIGS. 4A - 4C are enlarged plan views illustrating a partial area of the display panel;
FIG. 5A is a cross-sectional view of the display panel;
FIG. 5B is an enlarged cross-sectional view illustrating a partial area of the display panel;
FIG. 5C is a cross-sectional view illustrating a partial area of the display panel;
FIG. 6A is a cross-sectional view of a display panel;
FIG. 6B is an enlarged cross-sectional view illustrating a partial area of the display panel;
FIG. 7A is a cross-sectional view of a display panel;
FIG. 7B is an enlarged cross-sectional view illustrating a partial area of the display panel;
FIG. 7C is an enlarged cross-sectional view illustrating a partial area of the display panel;
FIG. 8A is a cross-sectional view of a display panel;
FIG. 8B is an enlarged cross-sectional view illustrating a partial area of the display panel;
FIG. 9 is an enlarged plan view illustrating a partial area of the display panel;
FIG. 10A is an enlarged cross-sectional view illustrating a partial area of the display panel;
FIG. 10B is an enlarged cross-sectional view illustrating a partial area of the display panel;
FIG. 11 is an enlarged plan view illustrating a partial area of the display panel; and
FIG. 12 is an enlarged plan view illustrating a partial area of the display panel.

### DETAILED DESCRIPTION

Because the present disclosure (including inventive concept) may have diverse modified embodiments, specific embodiments are illustrated in the drawings and are described in the detailed description of the present disclosure. However, this does not limit the present disclosure within specific embodiments and it should be understood that the present disclosure covers all the modifications, equivalents, and replacements within the idea and technical scope of the present disclosure.

In this specification, it will also be understood that when one component (or area, layer, portion) is referred to as being "on", "connected to", or "coupled to" another component, it can be directly disposed/connected/coupled on/to the one component, or an intervening third component may also be present.

In this specification, "directly disposed" may mean that there is no layer, film, area, plate, or the like between a portion of the layer, the layer, the area, the plate, and/or the like and the other portion. For example, "directly disposed" may mean being disposed without using an additional member such as an adhesive member between two layers or two members.

Like reference numerals refer to like elements throughout. Also, in the figures, the thickness, ratio, and dimensions of components are exaggerated for clarity of illustration. The term "and/or" includes any and all combinations of one or more of the associated listed items.

Throughout the present disclosure, the expression "at least one of a, b or c" indicates only a, only b, only c, both a and b, both a and c, both b and c, all of a, b, and c, or any variations thereof.

It will be understood that although the terms such as 'first' and 'second' are used herein to describe various elements, these elements should not be limited by these terms. These terms are used only to distinguish one component from other components. For example, a first element referred to as a first element in an embodiment can be referred to as a second element in another embodiment without departing from the scope of the appended claims and their equivalents. The terms of a singular form may include plural forms unless referred to the contrary.

Also, "under", "below", "above', "upper", and the like are used for explaining relation association of components illustrated in the drawings. The terms may be a relative concept and described based on directions expressed in the drawings. In this specification, the term "disposed on" may refer to a case in which it is disposed on a lower portion as well as an upper portion of any one member.

Unless otherwise defined, all terms (including technical and scientific terms) used herein have the same meaning as commonly understood by a person of ordinary skill in the art to which the present disclosure belongs. In addition, terms such as terms defined in commonly used dictionaries should be interpreted as having a meaning consistent with the meaning in the context of the related technology, and unless explicitly defined here, they are not interpreted as too ideal or too formal sense.

The meaning of "include" or "comprise" specifies a property, a fixed number, a step, an operation, an element, a component, and/or a combination thereof, but does not exclude other properties, fixed numbers, steps, operations, elements, components, and/or combinations thereof.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, a display device will be described with reference to the accompanying drawings.

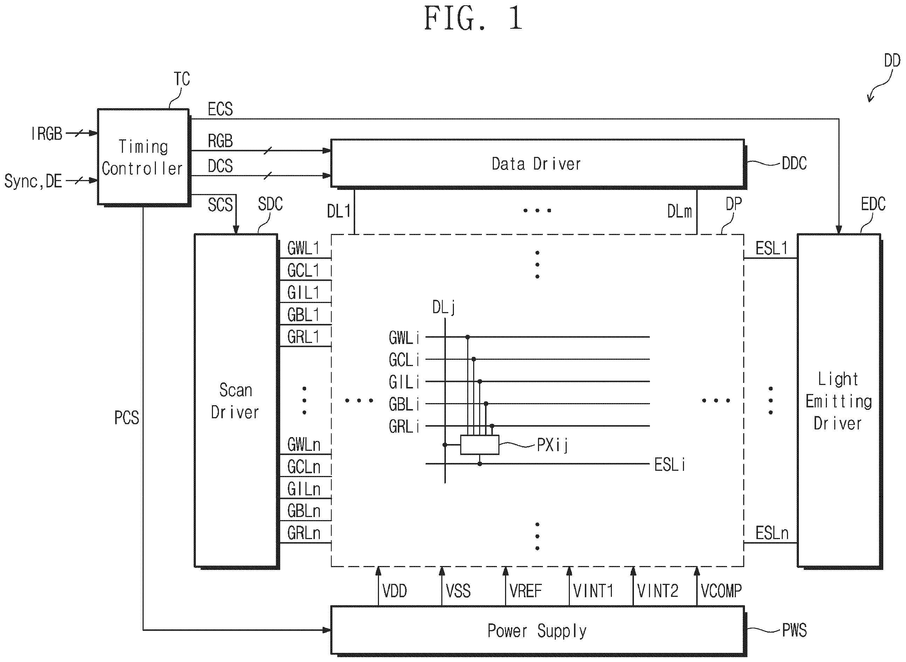

FIG. 1 is a block diagram of a display device DD. Referring to FIG. 1, a display device DD may include a display panel DP, panel drivers SDC, EDC, and DDC, a power supply PWS, and a timing controller TC. The display panel DP is described as an emission-type display panel. The emission-type display panel may include an organic light-emitting display panel, an inorganic light-emitting display panel, and/or a quantum dot light-emitting display panel. In one or more examples to be described later, an organic light-emitting display panel will be described in detail as an example. The panel drivers SDC, EDC, DDC may include a scan driver SDC, a light emitting driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include a plurality of pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm (however, m and n are integers greater than 1).

For example, the pixel PXij (where i and j are integers greater than 1) disposed on an i-th horizontal line (or an i-th pixel row) and a j-th vertical line (or a j-th pixel column) may be connected to an i-th first scan line GWLi (or write scan line), an i-th second scan line GCLi (or compensation scan line), an i-th third scan line GILi (or first initialization scan line), an i-th fourth scan line GBLi (or second initialization scan line), an i-th fifth scan line GRLi (or reset scan line), a j-th data line DLj, and an i-th emission line ESLi.

The pixel PXij may include a plurality of light emitting elements, a plurality of transistors, and/or a plurality of capacitors. The pixel PXij may receive a first power voltage VDD, a second power voltage VSS, a third power voltage VREF (or a reference voltage), a fourth power voltage VINT1 (or a first initialization voltage), a fifth power voltage VINT2 (or a second initialization voltage), and a sixth power voltage VCOMP (or a compensation voltage) through the power supply PWS.

A voltage value of each of the first power voltage VDD and the second power voltage VSS is set so that current flows through the light emitting element to emit light. For example, the first power voltage VDD may be set to a voltage higher than the second power voltage VSS.

The third power voltage VREF may be a voltage for initializing a gate of a driving transistor provided in the pixel PXij. The third power voltage VREF may be used to implement a suitable grayscale value or grayscale (e.g., a predetermined grayscale value or grayscale) by using a voltage difference with a data signal. For this, the third power voltage VREF may be set to a suitable voltage (e.g., a predetermined voltage) within a voltage range of the data signal.

The fourth power voltage VINT1 may be a voltage for initializing a capacitor provided in the pixel PXij. The fourth power voltage VINT1 may be set to a voltage lower than the third power voltage VREF. For example, the fourth power voltage VINT1 may be set to a voltage lower than a difference between the third power voltage VREF and the threshold voltage of the driving transistor. However, the present disclosure is not limited thereto.

The fifth power voltage VINT2 may be a voltage for initializing a cathode of the light emitting element provided in the pixel PXij. The fifth power voltage VINT2 may be set to a voltage lower than the first power voltage VDD or the fourth power voltage VINT1 or may be set to a voltage that is similar to or equal to the third power voltage VREF, but is not limited thereto. The fifth power voltage VINT2 may be set to a voltage that is similar to or equal to the first power voltage VDD.

The sixth power voltage VCOMP may supply a suitable current (e.g., a predetermined current) to the driving transistor when compensating for a threshold voltage of the driving transistor.

In FIG. 1, all of the first to sixth power voltages VDD, VSS, VREF, VINT1, VINT2, and VCOMP are supplied from the power supply PWS, but the present disclosure is not limited thereto. For example, all of the first power voltage VDD and the second power voltage VSS may be supplied regardless of the structure of the pixel PXij, and at least one voltage of the third power voltage VREF, the fourth power voltage VINT1, the fifth power voltage VINT2, and the sixth power voltage VCOMP may not be supplied to correspond to the structure of the pixel PXij.

Signal lines connected to the pixel PXij may be set variously to correspond to the circuit structure of the pixel PXij.

The scan driver SDC may receive a first control signal SCS from a timing controller TC and may supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn based on the first control signal SCS.

The scan signal may be set to a voltage at which the transistors receiving the scan signal are turned on. For example, a scan signal supplied to a P-type transistor may be set to a logic low level, and a scan signal supplied to an N-type transistor may be set to a logic high level. Hereinafter, the meaning of "that the scan signal is supplied" may be understood as that the scan signal is supplied with a logic level that turns on the transistor controlled thereby.

In FIG. 1, for convenience of description, the scan driver SDC is illustrated as a single configuration, but it is not limited thereto. A plurality of scan drivers may be provided to supply the scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The light emitting driver EDC may supply a light emitting signal to the emission lines ESL1 to ESLn based on a second control signal ECS. For example, the light emitting signal may be sequentially supplied to the emission lines ESL1 to ESLn.

The transistors connected to the emission lines ESL1 to ESLn of the present disclosure may be configured as N-type transistors. Here, the light emitting signal supplied to the emission lines ESL1 to ESLn may be set to a gate-off voltage. The transistors receiving the light emitting signal are turned off when the light emitting signal set to a gate-off voltage is supplied and may be turned on when the light emitting signal set to a gate-on voltage is supplied.

The second control signal ECS may include an emission start signal and clock signals, and the light emitting driver EDC may sequentially shift the emission start signal having a pulse form using the clock signals so as to be implemented as an axis resistor that sequentially generates and outputs the emission signal having pulse form.

The data driver DDC may receive the third control signal DCS and image data RGB from the timing controller TC. The data driver DDC may convert the digital image data RGB into an analog data signal (i.e., a data signal). The data driver DDC may supply data signals to the data lines DL1 to DLm in response to the third control signal DCS.

The third control signal DCS may include a data enable signal, a horizontal start signal, and a data clock signal, which instruct an output of a valid data signal. For example, the data driver DDC may include a shift register that generates a sampling signal by shifting the horizontal start signal in synchronization with the data clock signal, a latch that latches image data RGB in response to a sampling signal, a digital-to-analog converter (or a decoder) that converts the latched image data (e.g., digital data) into analog data signals, and buffers (or amplifiers) that output data signals to the data lines DL1 to DLm.

The power supply PWS may supply the first power voltage VDD, the second power voltage VSS, and the third power voltage VREF, which drive the pixel PXij, to the display panel DP. In addition, the power supply PWS may supply at least one of the fourth power voltage VINT1, the fifth power voltage VINT2, and the sixth power voltage VCOMP to the display panel DP.

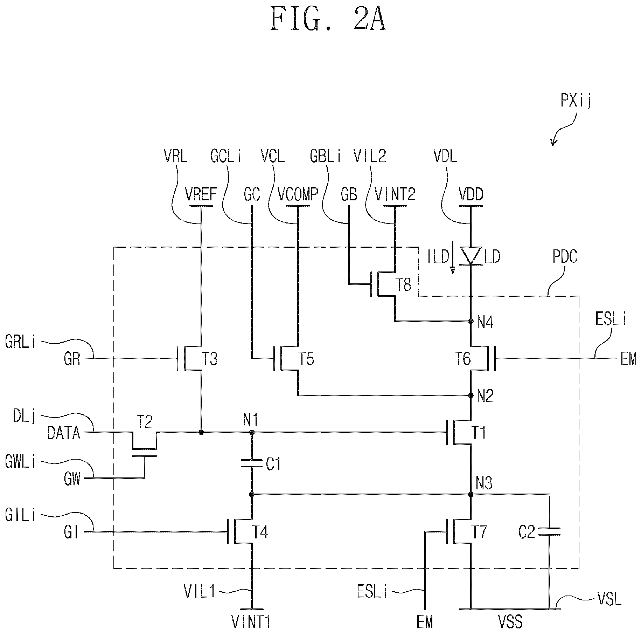

For example, the power supply PWS may supply the first power voltage VDD, the second power voltage VSS, the third power voltage VREF, the fourth power voltage VINT1, the fifth power voltage VINT2, and the sixth power voltage VCOMP to the display panel DP via a first power line VDL (e.g., see FIG. 2A), a second power line VSL (e.g., see FIG. 2A), a third power line VRL (or reference voltage line (e.g., see FIG. 2A)), a fourth power line (or first initialization voltage line VIL1 (e.g., see FIG. 2A), a fifth power line VIL2 (or a second initialization voltage line (e.g., see FIG. 2A)), and a sixth power line VCL (or compensation voltage line (e.g., see FIG. 2A)).

The power supply PWS may be implemented as a power management integrated circuit, but is not limited thereto.

The timing controller TC may generate the first control signal SCS, the second control signal ECS, the third control signal DCS, and the fourth control signal PCS based on an input image data IRGB, a synchronization signal Sync (e.g., vertical synchronization signal, a horizontal synchronization signal, etc.), a data enable signal DE, clock signal, etc. The first control signal SCS may be supplied to the scan driver SDC, the second control signal ECS may be supplied to the light emitting driver EDC, and the third control signal DCS may be supplied to the data driver DDC, and the fourth control signal PCS may be supplied to the power supply PWS. The timing controller TC may rearrange the input image data IRGB to correspond to the arrangement of the pixels PXij in the display panel DP, thereby generating the image data RGB (or frame data).

The scan driver SDC, the light emitting driver EDC, the data driver DDC, the power supply PWS, and/or the timing controller TC may be provided directly on the display panel DP or provided in the form of a separate driving chip so as to be connected to the display panel DP. In addition, at least two of the scan driver SDC, the light emitting driver EDC, the data driver DDC, the power supply PWS, and the timing controller TC may be provided as one driving chip. For example, the data driver DDC and the timing controller TC may be provided as one driving chip.

In the above, the display device DD has been described with reference to FIG. 1, but the present disclosure is not limited thereto. The signal lines may be further added or omitted according to the configuration of the pixels. Also, a connection relationship between one pixel and the signal lines may be changed. When one of the signal lines is omitted, another signal line may replace the omitted signal line.

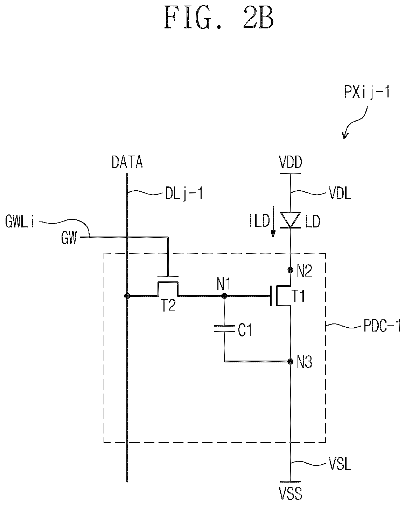

FIGS. 2A and 2B are equivalent circuit diagrams of the pixel of the present disclosure. In FIGS. 2A and 2B, equivalent circuit diagrams of the pixels PXij and PXij-1 connected to the i-th first scan line GWLi (hereinafter, referred to as a first scan line) and connected to the j-th data line DLj (hereinafter, referred to as a data line) are illustrated as an example.

As illustrated in FIG. 2A, the pixel PXij includes a light emitting element LD and a pixel driver PDC. The light emitting element LD is connected to the first power line VDL and the pixel driver PDC.

The pixel driver PDC may be connected to the plurality of scan lines GWLi, GCLi, GILi, GBLi, and GRLi, the data line DLj, the emission line ESLi, and the plurality of power voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, a case in which each of the first to eighth transistors T1, T2, T3, T4, T5, T6, T7, and T8 is an N-type transistor will be described as an example. However, the present disclosure is not limited thereto, and some of the first to eighth transistors T1 to T8 may be N-type transistors, others may be P-type transistors, and each of the first to eighth transistors T1 to T8 may be a P-type transistor.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control driving current ILD flowing from the first power line VDL to the second power line VSL via the light emitting element LD in response to a voltage of the first node N1. In this case, the first power voltage VDD may be set to a voltage having a potential higher than that of the second power voltage VSS.

In this specification, "that is electrically connected between the transistor and the signal line or between the transistor and the transistor" means "that a source, a drain, and a gate of the transistor have an integral shape with the signal line or are connected through a connection electrode."

The second transistor T2 may include a gate connected to the write scan line GWLi, a first electrode connected to the data line DLj, and a second electrode connected to the first node N1. The second transistor T2 may supply a data signal DATA to the first node N1 in response to the write scan signal GW transmitted through the write scan line GWLi. The second transistor T2 may be turned on when the write scan signal GW is supplied to the write scan line GWLi to electrically connect the data line DLj to the first node N1.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In this example, the gate of the third transistor T3 may receive a reset scan signal GR through the i-th fifth scan line GRLi (hereinafter, referred to as a reset scan line). The third transistor T3 may be turned on when the reset scan signal GR is supplied to the reset scan line GRLi to provide the reference voltage VREF to the first node N1.

The fourth transistor T4 may be connected between the third node N3 and the first initialization voltage line VIL1. The first electrode of the fourth transistor T4 may be connected to the third node N3, and the second electrode of the fourth transistor T4 may be connected to the first initialization voltage line VIL1 providing the first initialization voltage VINT1. The fourth transistor T4 may be referred to as a first initialization transistor. A gate of the fourth transistor T4 may receive a first initialization scan signal GI through the i-th third scan line GILi (hereinafter, referred to as a first initialization scan line). The fourth transistor T4 may be turned on when the first initialization scan signal GI is supplied to the first initialization scan line GILi to supply the first initialization voltage VINT1 to the third node N3.

The fifth transistor T5 may be connected between the compensation voltage line VCL and the second node N2. The first electrode of the fifth transistor T5 may receive the compensation voltage VCOMP through the compensation voltage line VCL, and the second electrode of the fifth transistor T5 may be connected to the second node N2 so as to be electrically connected to the first electrode of the first transistor T1. A gate of the fifth transistor T5 may receive a compensation scan signal GC through the i-th second scan line GCLi (hereinafter, referred to as a compensation scan line). The fifth transistor T5 may be turned on when the compensation scan signal GC is supplied to the compensation scan line GCLi to provide the compensation voltage VCOMP to the second node N2, and thus, a threshold voltage of the first transistor T1 may be compensated during a compensation period.

The sixth transistor T6 may be connected between the first transistor T1 and the light emitting element LD. Specifically, a gate of the sixth transistor T6 may receive the light emitting signal EM through the i-th emission line ESLi (hereinafter, referred to as an emission line). The first electrode of the sixth transistor T6 may be connected to a cathode of the light emitting element LD through the fourth node N4, and the second electrode of the sixth transistor T6 may be connected to the first electrode of the first transistor T1 through the second node N2. The sixth transistor T6 may be referred to as a first emission control transistor. When the light emitting signal EM set to a gate-on voltage is supplied to the emission line ESLi, the sixth transistor T6 may be turned on to electrically connect the light emitting element LD to the first transistor T1.

The seventh transistor T7 may be connected between the second power line VSL and the third node N3. The first electrode of the seventh transistor T7 may be connected to the second electrode of the first transistor T1 through the third node N3, and the second electrode of the seventh transistor T7 may receive the second power voltage VSS through the second power line VSL. A gate of the seventh transistor T7 may be electrically connected to the emission line ESLi. The seventh transistor T7 may be referred to as a second emission control transistor. When the light emitting signal EM having a gate-on voltage is supplied to the emission line ESLi, the seventh transistor T7 may be turned on to electrically connect the second electrode of the first transistor T1 to the second power line VSL.

In this example, the sixth transistor T6 and the seventh transistor T7 may be connected to the same emission line ESLi and turned on through the same light emitting signal EM, but this is merely an example. For example, the sixth transistor T6 and the seventh transistor T7 may be independently turned on by different signals that are distinguished from each other. In addition, in the pixel driver PDC, either the sixth transistor T6 or the seventh transistor T7 may be omitted.

The eighth transistor T8 may be connected between the second initialization voltage line VIL2 and the fourth node N4. That is, the eighth transistor T8 may include a gate connected to the i-th fourth scan line GBLi (hereinafter, referred to as a second initialization scan line), a first electrode connected to the second initialization voltage line VIL2, and a second electrode connected to a fourth node N4. The eighth transistor T8 may be referred to as a second initialization transistor. The eighth transistor T8 may supply the second initialization voltage VINT2 to the fourth node N4 corresponding to the cathode of the light emitting element LD in response to the second initialization scan signal GB transmitted through the second initialization scan line GBLi. The cathode of the light emitting element LD may be initialized by the second initialization voltage VINT2.

Some of the second to eighth transistors T2, T3, T4, T5, T6, T7, and T8 may be concurrently (e.g., simultaneously) turned on through the same scan signal. For example, the eighth transistor T8 and the fifth transistor T5 may be concurrently (e.g., simultaneously) turned on through the same scan signal. For example, the eighth transistor T8 and the fifth transistor T5 may operate by the same compensation scan signal GC or the same second initialization scan signal GB. The eighth transistor T8 and the fifth transistor T5 may be concurrently (e.g., simultaneously) turned on/off by the same compensation scan signal GC or the same second initialization scan signal GB. In this case, the compensation scan line GCLi and the second initialization scan line GBLi may be substantially provided as a single scan line. Thus, the initialization of the cathode of the light emitting element LD and the compensation of the threshold voltage of the first transistor T1 may be performed at the same timing. However, this is merely an example and is not limited thereto.

In addition, the initialization of the cathode of the light emitting element LD and the compensation of the threshold voltage of the first transistor T1 may be performed by applying the same power voltage. For example, the compensation voltage line VCL and the second initialization voltage line VIL2 may be substantially provided as a single power voltage line. In this case, the cathode initialization operation and the compensation operation of the driving transistor may be performed at one power voltage, and thus, a design of the driver may be simplified. However, this is merely an example, and the present disclosure is not limited thereto.

The first capacitor C1 may be disposed between the first node N1 and the third node N3. The first capacitor C1 may store a difference voltage between the first node N1 and the third node N3. The first capacitor C1 may be referred to as a storage capacitor.

The second capacitor C2 may be disposed between the third node N3 and the second power line VSL. That is, one electrode of the second capacitor C2 may be connected to the second power line VSL receiving the second power voltage VSS, and the other electrode of the second capacitor C2 may be connected to the third node N3. The second capacitor C2 may store a charge corresponding to a voltage difference between the second power voltage VSS and the third node N3. The second capacitor C2 may be referred to as a hold capacitor. The second capacitor C2 may have a storage capacity greater than that of the first capacitor C1. Thus, the second capacitor C2 may reduce or minimize a voltage change of the third node N3 in response to a voltage change of the first node N1.

In this example, the light emitting element LD may be connected to the pixel driver PDC through the fourth node N4. The light emitting element LD may include a first electrode (anode) connected to the first power line VDL and a second electrode (cathode) opposite thereto. In this example, the light emitting element LD may be connected to the pixel driver PDC through the cathode. That is, in the pixel PXij, a connection node at which the light emitting element LD and the pixel driver PDC are connected may be the fourth node N4, and the fourth node N4 may correspond to a connection node between the first electrode of the sixth transistor T6 and the cathode of the light emitting element LD. Thus, a potential of the fourth node N4 may substantially correspond to a potential of the cathode of the light emitting element LD.

Specifically, the anode of the light emitting element LD may be connected to the first power line VDL to receive the first power voltage VDD, which is a constant voltage, and the cathode may be connected to the first transistor T1 through the sixth transistor T6. That is, in this example in which the first to eighth transistors T1 to T8 are N-type transistors, the potential of the third node N3 corresponding to the source of the first transistor T1, which is the driving transistor, may not be directly affected by the characteristics of the light emitting element LD. Therefore, even if the light emitting element LD is deteriorated, an effect on the transistors constituting the pixel driver PDC, particularly a gate-source voltage Vgs of the driving transistor, may be reduced. That is, because an amount of change in driving current due to the deterioration of the light emitting element LD may be reduced, afterimage defects of the display panel according to an increase in use time may be reduced to improve a lifespan and efficiency of the display panel.

Alternatively, as illustrated in FIG. 2B, the pixel PXij-1 may include a pixel driver PDC-1 including two transistors T1 and T2 and one capacitor C1. The pixel driver PDC-1 may be connected to the light emitting element LD, the write scan line GWLi, the data line DLj-1, and the second power line VSL. The pixel driver PDC-1 illustrated in FIG. 2B may correspond to a case in which the third to eighth transistors T3 to T8 and the second capacitor C2 are omitted in the pixel driver PDC illustrated in FIG. 2A.

Each of the first and second transistors T1 and T2 may be an N-type or a P-type transistor. In this example, each of the first and second transistors T1 and T2 will be described as an N-type transistor as an example.

The first transistor T1 may include a gate connected to the first node N1, a first electrode connected to the second node N2, and a second electrode connected to the third node N3. The second node N2 may be a node connected to a side of the first power line VDL, and the third node N3 may be a node connected to a side of the second power line VSL. The first transistor T1 may be connected to the light emitting element LD through the second node N2 and connected to the second power line VSL through the third node N3. The first transistor T1 may be a driving transistor.

The second transistor T2 may include a gate receiving the write scan signal GW through the write scan line GWLi, a first electrode connected to the data line DLj-1, and a second electrode connected to the first node N1. The second transistor T2 may supply a data signal DATA to the first node N1 in response to the write scan signal GW transmitted through the write scan line GWLi.

The first capacitor C1 may include an electrode connected to the first node N1 and an electrode connected to the third node N3. The first capacitor C1 may store a data signal DATA transmitted to the first node N1.

The light emitting element LD may include an anode (or first electrode) and a cathode (or second electrode). In this example, the anode of the light emitting element LD may be connected to the first power line VDL, and the cathode may be connected to the pixel driver PDC-1 through the second node N2. In this example, the cathode of the light emitting element LD may be connected to the first transistor T1. The light emitting element LD may emit light in response to an amount of current flowing through the first transistor T1 of the pixel driver PDC-1.

In this example in which the first and second transistors T1 and T2 are the N-type transistors, the second node N2 at which the cathode of the light emitting element LD and the pixel driver PDC-1 are connected may correspond to the drain of the transistor T1. That is, a change in gate-source voltage Vgs of the first transistor T1 caused by the light emitting element LD may be reduced or prevented. Thus, because an amount of change in driving current due to the deterioration of the light emitting element LD may be reduced, afterimage defects of the display panel according to an increase in use time may be reduced to improve a lifespan and efficiency of the display panel.

FIGS. 2A and 2B illustrate circuits for the pixel drivers PDC and PDC-1, and in the display panel, if the circuit is connected to the cathode of the light emitting element LD, the number or arrangement of transistors and the number or arrangement of capacitors may be designed in various manners.

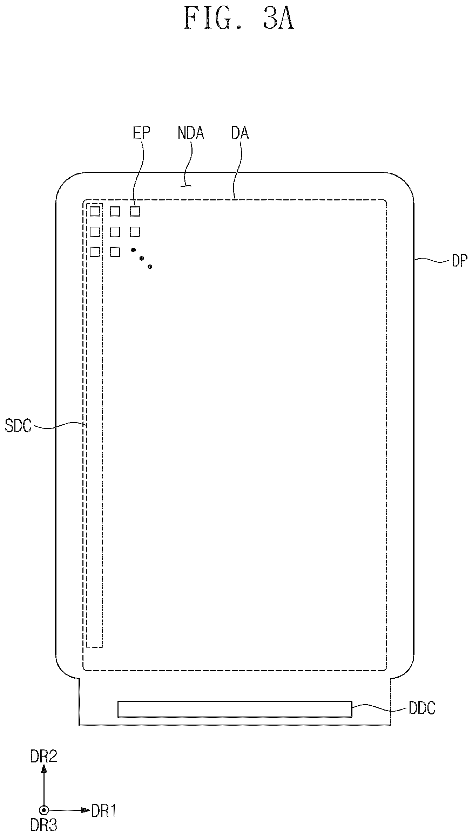

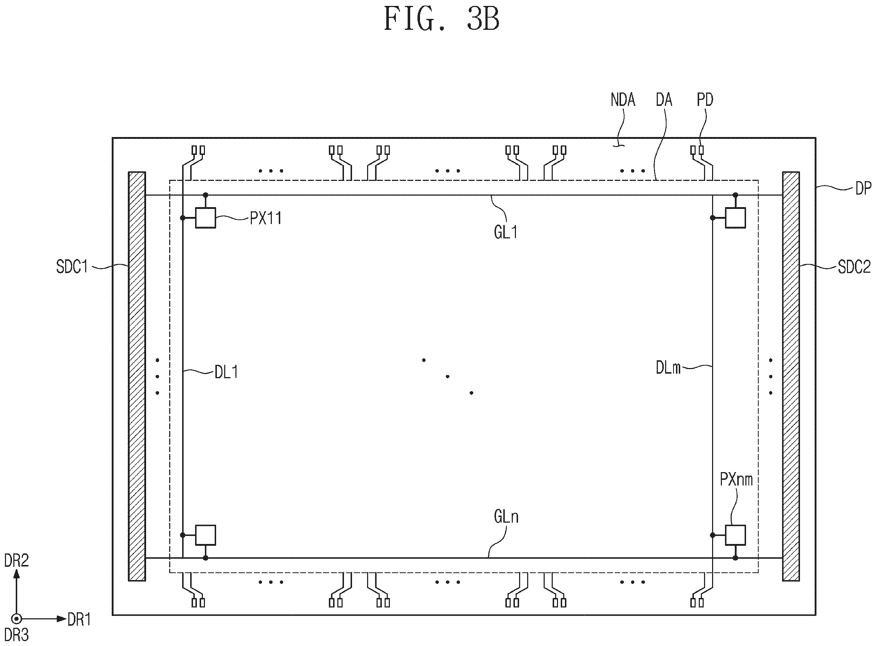

FIGS. 3A and 3B are plan views of the display panel. In each of FIGS. 3A and 3B, some components are omitted. Hereinafter, an example will be described with reference to FIGS. 3A and 3B. Referring to FIG. 3A, the display panel DP may be divided into a display area DA and a peripheral area NDA (or non-display area) disposed around the display area DA along an edge or a periphery of the display area DA. The display area DA may include a plurality of light emitting parts EP.

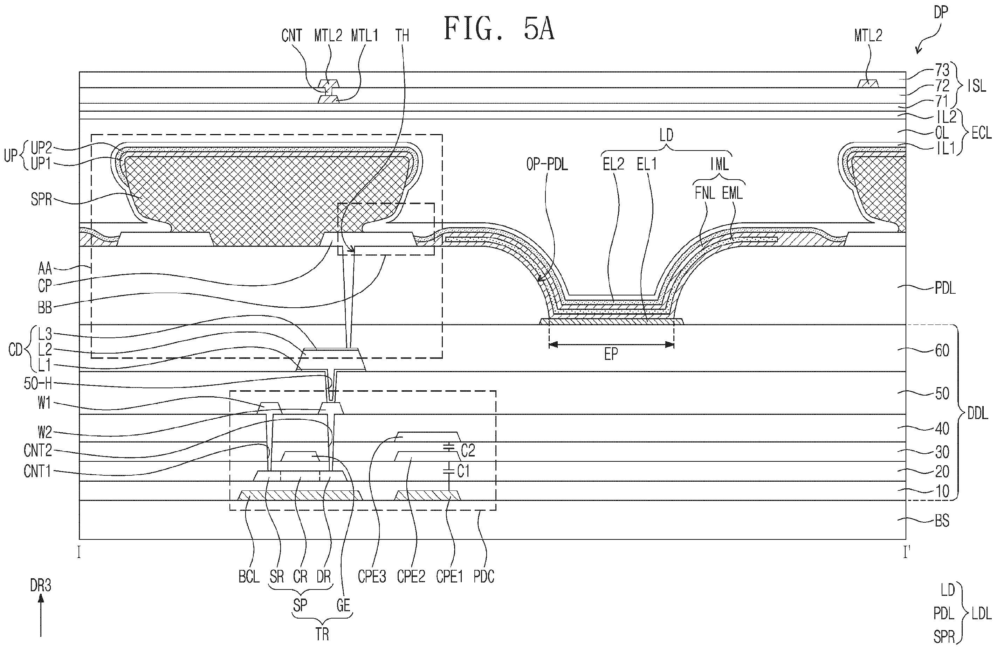

The light emitting parts EP may be areas that respectively emit light by the pixels PXij (see FIG. 1). Specifically, each of the light emitting parts EP may be a portion corresponding to a light emitting opening OP-PDL (e.g., see FIG. 5A) to be described later.

The peripheral area NDA may be disposed adjacent to the display area DA. In this example, the peripheral area NDA has a shape surrounding an edge of the display area DA. However, this is merely an example, and the peripheral area NDA may be disposed at one side of the display area DA or may be omitted.

The scan driver SDC and the data driver DDC may be mounted on the display panel DP. The scan driver SDC may be disposed on the display area DA, and the data driver DDC may be disposed on the peripheral area NDA. The scan driver SDC may overlap at least a portion of the light emitting parts EP disposed on the display area DA on a plane (e.g., in a plan view). As the scan driver SDC is disposed on the display area DA, a surface area of the peripheral area NDA may be reduced when compared to the display panel, in which the scan driver is disposed on the peripheral area NDA according to the related art, and thus, a display device having a thin bezel may be easily implemented.

Unlike what is illustrated in FIG. 3A, the scan driver SDC may be provided as two portions that are distinguished from each other. The two scan drivers SDC may be spaced (e.g., spaced apart) from each other in a left to right direction with respect to a center of the display area DA. Alternatively, the scan drivers SDC may be provided in a larger number than two, and is not limited.

FIG. 3A illustrates an example of the display panel, and in other examples, the data driver DDC may be disposed on the display area DA. In this case, some of the light emitting parts EP disposed on the display area DA may overlap the data driver DDC on the plane (e.g., in a plan view).

The data driver DDC may be provided in the form of a separate driving chip independent of the display panel DP and may be connected to the display panel DP. However, this is merely an example, and the data driver DDC may be formed in the same process as the scan driver SDC to constitute the display panel DP.

As illustrated in FIG. 3B, the display panel DP may have a shape in which a length corresponding to a first direction DR1 is greater than a length corresponding to a second direction DR2. The display area DA is illustrated as having a plurality of n-type pixels (PX11 to PXnm) arranged in m columns as an example. The display panel DP may include a plurality of scan drivers SDC1 and SDC2 in the peripheral area NDA. The scan drivers SDC1 and SDC2 are illustrated as including a first scan driver SDC1 and a second scan driver SDC2, which are spaced (e.g., spaced apart) from each other in the first direction DR1.

The first scan driver SDC1 may be connected to some of the scan lines GL1 to GLn, and the second scan driver SDC2 may be connected to other ones of the scan lines GL1 to GLn. For example, the first scan driver SDC1 may be connected to odd-numbered scan lines from among the scan lines GL1 to GLn, and the second scan driver SDC2 may be connected to even-numbered scan lines from among the scan lines GL1 to GLn.

FIG. 3B illustrates pads PD of the data lines DL1 to DLm for easy description. The pads PD may be defined at ends of the data lines DL1 to DLm. The data lines DL1 to DLm may be connected to the data driver DDC (see FIG. 3A) through the pads PD disposed in the peripheral area NDA.

The pads PD may be divided and arranged at positions on the peripheral area NDA, which are spaced (e.g., spaced apart) from each other with the display area DA therebetween. For example, some of the pads PD may be disposed at an upper side, that is, at a side adjacent to the first scan line GL1 from among the scan lines GL1 to GLn, and other ones of the pads PD may be disposed at a lower side, that is, at a side adjacent to the last scan line GLn from among the scan lines GL1 to GLn. In this example, the pads PD connected to the odd-numbered data lines from among the data lines DL1 to DLm may be disposed at the upper side, and the pads PD connected to the even-numbered data lines from among the data lines DL1 to DLm may be disposed at the lower side.

The display panel DP includes a plurality of upper data drivers connected to the pads PD disposed at the upper side and/or a plurality of lower data drivers connected to the pads PD disposed at the lower side in the peripheral area NDA. However, this is merely an example, and the display panel DP may include one upper data driver connected to the pads PD disposed at the upper side in the peripheral area NDA and/or one lower data driver connected to the pads PD disposed at the lower side in the peripheral area NDA. The pads PD may be disposed at only one side of the display panel DP and thus connected to a single data driver.

Also, as described above with reference to FIG. 3A, in the display panel DP in FIG. 3B, the scan driver and/or a data driver may also be disposed on the display area DA, and thus, some of the light emitting parts disposed on the display area DA may overlap the scan driver and/or the data driver on the plane (e.g., in a plan view).

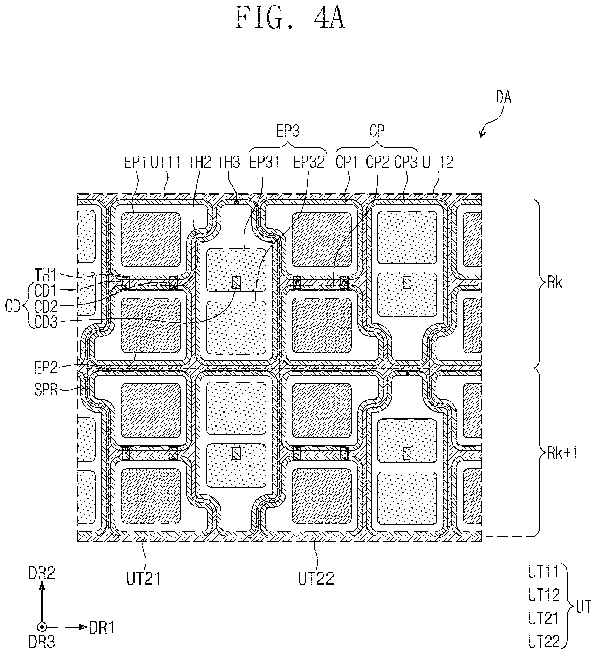

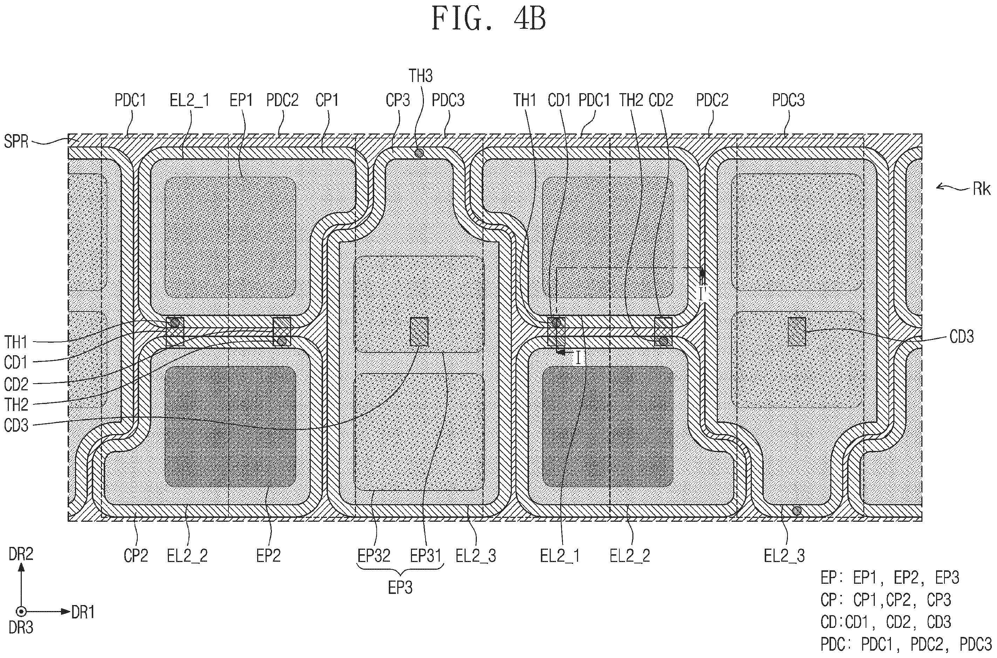

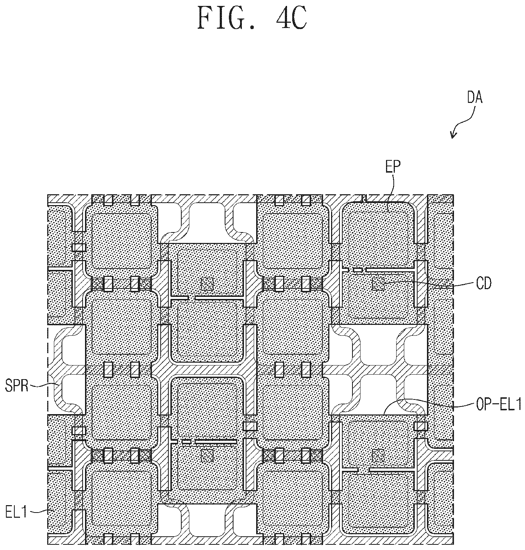

FIGS. 4A - 4C are plan views of the display panel (e.g., of FIG. 1) of the present disclosure. FIG. 4A illustrates an area on which a total of four light emitting units UT in two rows and two columns are disposed, and FIG. 4B illustrates an enlarged view of a partial area illustrated in FIG. 4A. In FIG. 4C, some of the components illustrated in FIG. 4A are omitted or emphasized. Hereinafter, one or more examples will be described with reference to FIGS. 4A - 4C.

FIG. 4A illustrates light emitting units UT11, UT12, UT21, and UT22 in two rows and two columns. The light emitting parts in a first row Rk include the light emitting parts constituting a first row first column light emitting unit UT11 and a first row second column light emitting unit UT12, and the light emitting parts in a second row Rk+1 include the light emitting parts constituting a second row first column light emitting unit UT21 and a second row second column light emitting unit UT22. FIG. 4B illustrates the light emitting parts in the first row Rk. FIGS. 4A - 4C illustrate a separator SPR, a plurality of light emitting parts EP1, EP2, and EP3 disposed on an area partitioned by the separator SPR, driving connection parts CD1, CD2, and CD3, through-holes TH1, TH2, and TH3, conductive patterns CP1, CP2, and CP3, a first electrode EL1, and second electrodes EL2_1, EL2_2, and EL2_3 from among components of the display panel.

As described above, each of the light emitting parts EP1, EP2, and EP3 may correspond to a light emitting opening OP-PDL to be described later. That is, each of the light emitting parts EP1, EP2, and EP3 may be an area from which light is emitted by the above-described light emitting element and may correspond to a unit constituting an image displayed on the display panel DP (see FIG. 1). More specifically, each of the light emitting parts EP1, EP2, and EP3 may correspond to an area defined by the light emitting opening OP-PDL (FIG. 5A) to be described later, particularly an area defined by a bottom surface of the light emitting opening OP-PDL.

The light emitting parts EP1, EP2, and EP3 may include a first light emitting part EP1, a second light emitting part EP2, and a third light emitting part EP3. The first light emitting part EP1, the second light emitting part EP2, and the third light emitting part EP3 may emit light having colors different from each other. For example, the first light emitting part EP1 may emit red light, the second light emitting part EP2 may emit green light, and the third light emitting part EP3 may emit blue light, but the combination of the colors is not limited thereto. In addition, at least two or more of the light emitting parts EP1, EP2, and EP3 may emit light having the same color. For example, all of the first to third light emitting parts EP1, EP2, and EP3 may emit blue light and/or emit white light.

In the light emitting parts EP1, EP2, and EP3, the third light emitting part EP3 displaying light emitted by the third light emitting element may include two sub light emitting parts EP31 and EP32 that are spaced (e.g., spaced apart) from each other in the second direction DR2. However, this is merely an example, and the third light emitting part EP3 may be provided in one pattern having an integral shape, like the other light emitting parts EP1 and EP2 and may include sub light emitting parts, in which at least one of other light emitting parts EP1 and EP2 are spaced (e.g., spaced apart) from each other.

The light emitting parts in a first row Rk may include the light emitting parts EP1, EP2, and EP3 constituting a first row first column light emitting unit UT11 and a first row second column light emitting unit UT12, and the light emitting parts in a second row Rk+1 include the light emitting parts EP1, EP2, and EP3 constituting a second row first column light emitting unit UT21 and a second row second column light emitting unit UT22. Some of the light emitting parts in the first row Rk and some of the light emitting parts in the second row Rk+1 may have symmetrical shapes. For example, the first light emitting part EP1 and the second light emitting part EP2 of the second row first column light emitting unit UT21 and the first light emitting part EP1 and the second light emitting part EP2 of the first row first column light emitting unit UT11 may have a axisymmetric shape and arrangement with respect to an axis parallel to the first direction DR1, and the third light emitting part EP3 of the second row and first column light emitting unit UT21 and the third light emitting part EP3 of the first row and first column light emitting unit UT11 may have a shape and arrangement that are axisymmetric with respect to an axis parallel to the first direction DR1. However, this is merely an example, and the present disclosure is not limited thereto.

Hereinafter, the first row first column light emitting unit UT11 will be described. In FIG. 4B, for ease of explanation, a plurality of second electrodes EL2_1, EL2_2, and EL2_3, a plurality of pixel drivers PDC1, PDC2, and PDC3, a plurality of driving connection parts CD1, CD2, and CD3, and a plurality of through-holes TH1, TH2, and TH3, and a plurality of conductive patterns CP1, CP2, and CP3 are illustrated. The second electrodes EL2_1, EL2_2, and EL2_3 may be electrically disconnected from each other by being separated from each other by the separator SPR. In this example, one light emitting unit UT may include three light emitting parts EP1, EP2, and EP3. Thus, the light emitting unit UT may include three second electrodes EL2_1, EL2_2, and EL2_3 (hereinafter, referred to as first to third cathodes), and three pixel drivers PDC1, PDC2, and PDC3. In addition, one light emitting unit UT may include three conductive patterns CP1, CP2, and CP3 that electrically connect the pixel drivers PDC1, PDC2, and PDC3 respectively corresponding to the first to third cathodes EL2_1, EL2_2, and EL2_3, and three through-holes TH1, TH2, and TH3 in which the conductive patterns CP1, CP2, and CP3 are respectively disposed. However, this is merely an example, and the number and arrangement of the light emitting units UT may be designed in various manners. In addition, the arrangement of the conductive patterns CP1, CP2, and CP3 and the positions and number of the conductive through-holes TH1, TH2, and TH3 may be designed in various manners.

The first to third pixel drivers PDC1, PDC2, and PDC3 is electrically connected to the light emitting elements constituting the first to third light emitting parts EP1, EP2, and EP3, respectively. In this specification, "connected" includes not only a case of being physically connected by direct contact, but also a case of being electrically connected.

In addition, as illustrated in FIG. 4B, in each area on which the pixel drivers PDC1, PDC2, and PDC3 are defined on the plane (e.g., in a plan view) may correspond to units in which the transistor and capacitor elements constituting the pixel driver PDC for driving the light emitting element of the pixel are repeatedly arranged.

The first to third pixel drivers PDC1, PDC2, and PDC3 may be sequentially disposed along the first direction DR1. The disposed positions of the first to third pixel drivers PDC1, PDC2, and PDC3 may be independently designed regardless of the positions or shapes of the first to third light emitting parts EP1, EP2, and EP3.

For example, the first to third pixel drivers PDC1, PDC2, and PDC3 may be designed to be disposed on an area defined by being partitioned by the separator SPR, that is, a position different from the position at which the first to third cathodes EL2_1, EL2_2, and EL2_3 are disposed or to have a shape and surface area different from those of the first to third cathodes EL2_1, EL2_2, and EL2_3. Alternatively, the first to third pixel drivers PDC1, PDC2, and PDC3 may be designed to be disposed to overlap the positions at which the first to third light emitting parts EP1, EP2, and EP3 are present and to be disposed on an area defined by being partitioned by a separator SPR, for example, in a shape having a shape and surface area similar to those of the first to third cathodes EL2_1, EL2_2, and EL2_3.

In this example, each of the first to third pixel drivers PDC1, PDC2, and PDC3 is illustrated in a rectangular shape, and each of the first to third light emitting parts EP1, EP2, and EP3 may have a surface area less than that of each of the first to third pixel drivers PDC1, PDC2, and PDC3 and a shape different from that of each of the first to third pixel drivers PDC1, PDC2, and PDC3, and the first to third cathodes EL2_1, EL2_2, and EL2_3 may be disposed at positions overlapping the first to third light emitting parts EP1, EP2, and EP3 and provided in irregular shapes.

Thus, as illustrated in FIG. 4B, the first pixel driver PDC1 may be disposed at a position that partially overlaps the first light emitting part EP1, the second light emitting part EP2, and other light emitting parts adjacent thereto. The second pixel driver PDC2 may be disposed at a position overlapping the first light emitting part EP1, the second light emitting part EP2, and the third light emitting part EP3. The third pixel driver PDC3 may be disposed at a position overlapping the third light emitting part EP3. This is merely an example, and the positions of the first to third pixel drivers PDC1, PDC2, and PDC3 may be designed in various shapes and arrangements independently of the light emitting parts EP1, EP2, and EP3.

A display device includes a conductive pattern CP. The conductive pattern CP may be provided as a plurality of patterns.

The conductive pattern CP may be provided to correspond to each of the light emitting parts EP1, EP2, and EP3. The conductive pattern CP may be disposed below the separator SPR along the shape of the separator SPR. The conductive patterns CP may include a first conductive pattern CP1 disposed adjacent to the first light emitting part EP1, a second conductive pattern CP2 disposed adjacent to the second light emitting part EP2, and a third conductive pattern CP3 disposed adjacent to a third light emitting part EP3. For example, the first to third conductive patterns CP1, CP2, and CP3 may be disposed to be around (e.g., to surround) the corresponding first to third light emitting parts EP1, EP2, and EP3, respectively. When viewed on the plane (e.g., in a plan view), the first to third conductive patterns CP1, CP2, and CP3 may have a closed line shape arranged to be around (e.g., to surround) the corresponding first to third light emitting parts EP1, EP2, and EP3, respectively.

However, the present disclosure is not limited thereto. The conductive pattern CP may be disposed below the separator SPR and may be disposed to overlap only a portion of the separator SPR. That is, the conductive pattern CP may overlap only a portion of the separator SPR on the plane (e.g., in a plan view). Unlike the illustrated shape, the conductive pattern CP may not be around (e.g., may not surround) the light emitting parts EP1, EP2, and EP3, but may be disposed adjacent to only at least one surface of the light emitting parts EP1, EP2, and EP3. That is, each of the conductive patterns CP may be disposed on only one side of each of the light emitting parts EP1, EP2, and EP3, or may be disposed to cover only a partial area of each of the light emitting parts EP1, EP2, and EP3. For example, on the plane (e.g., in a plan view), the conductive pattern CP may have a straight line shape or a line shape including a curved portion.

In this specification, "on the plane," "when viewed on the plane," or "in a plan view" may mean a plane parallel to the plane defined by first and second direction DR1 and DR2.

The conductive patterns CP may be disposed to overlap the separator SPR on the plane (e.g., in a plan view). Each of the conductive patterns CP may entirely overlap the separator SPR, or at least a portion of each of the conductive patterns CP may overlap the separator SPR on the plane (e.g., in a plan view). A partial area of the conductive pattern CP may be disposed below the separator SPR to protrude from an edge of the overlapping separator SPR. However, and one edge of the conductive pattern CP may overlap one edge of the overlapping separator SPR, or one edge of the conductive pattern CP may be spaced (e.g., spaced apart) from the light emitting part EP to overlap the inside of the separator SPR on the plane (e.g., in a plan view).

Two conductive patterns corresponding to the two light emitting parts may be disposed below the separator SPR, which separates the adjacent light emitting parts EP1, EP2, and EP3 from each other and is disposed between two light emitting parts. For example, the first conductive pattern CP1 and the second conductive pattern CP2 may be disposed below the separator SPR that separates the first light emitting part EP1 from the second light emitting part EP2, the first conductive pattern CP1 and the third conductive pattern CP3 may be disposed below the separator SPR that separates the first light emitting part EP1 from the third light emitting part EP3, and the second light emitting part EP2 and the third light emitting part EP3 may be disposed below the separator SPR that separates the second conductive pattern CP2 from the third conductive pattern CP3. However, when the conductive patterns CP1, CP2, and CP3 are provided adjacent to only some surfaces of the light emitting parts EP1, EP2, and EP3, only one conductive pattern may be disposed below the separator SPR disposed between the two light emitting parts.

One conductive pattern CP may electrically connect one of the pixel drivers PDC1, PDC2, and PDC3 to the corresponding light emitting element. Specifically, the conductive pattern CP may correspond to a node (the fourth node N4 in FIG. 2A or the second node N2 in FIG. 2B) connected to the pixel driver (PDC in FIG. 2A or PDC-1 in FIG. 2B).

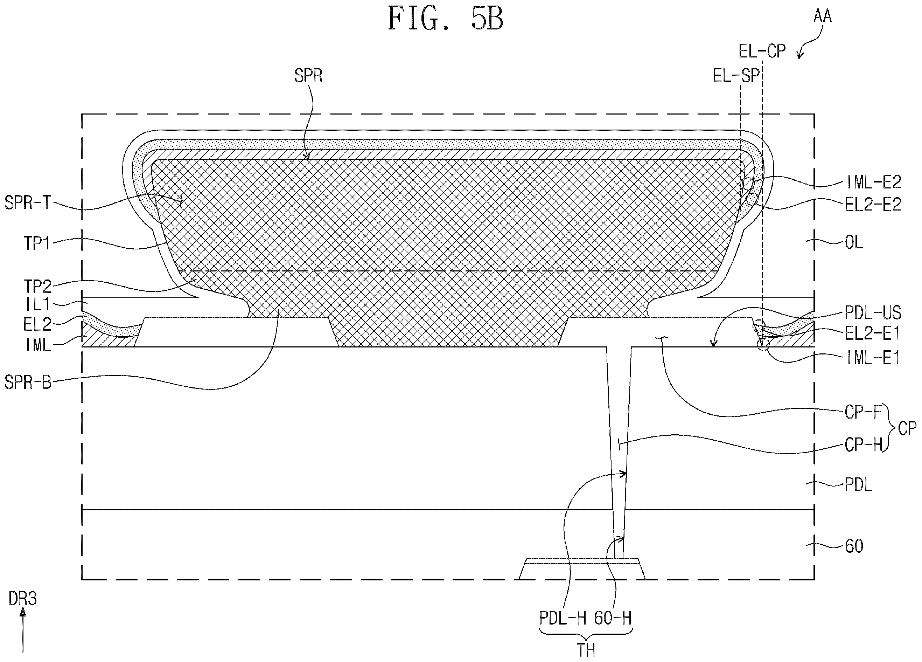

The conductive patterns CP1, CP2, and CP3 may be electrically connected to one electrode of the transistor constituting the pixel driver PDC. In addition, the conductive patterns CP1, CP2, and CP3 may be connected to the second electrode (or cathode EL2 in FIG. 5A) of the light emitting element. For example, a contact part CP-H (see FIG. 5B) of the conductive patterns CP1, CP2, and CP3 to be described later may be connected to the transistor through the driving connection parts CD1, CD2, and CD3, and an extension part CP-F (see FIG. 5B) of the conductive patterns CP1, CP2, and CP3 may be connected to the cathode EL2 (FIG. 5A). In the conductive patterns CP1, CP2, and CP3, a contact part CP-H (see FIG. 5B) may be a portion disposed to fill the through-hole TH, and an extension part CP-F (see FIG. 5B) may be a portion connected to a contact part CP-H (see FIG. 5B).

The first conductive pattern CP1 may connect the light emitting element and the first pixel driver PDC1, which constitute the first light emitting part EP1, to each other, the second conductive pattern CP2 may connect the light emitting element and the second pixel driver PDC2, which constitute the second light emitting part EP2, to each other, and the third conductive pattern CP3 may connect the light emitting element and the third pixel driver PDC3, which constitute the third light emitting part EP3, to each other.

Specifically, the first to third conductive patterns CP1, CP2, and CP3 may connect the first to third cathodes EL2_1, EL2_2, and EL2_3 to the first to third pixel drivers PDC1, PDC2, and PDC3, respectively. The first conductive pattern CP1 may electrically connect the first driving connection part CD1 connected to the first pixel driver PDC1 to the first cathode EL2_1. The second conductive pattern CP2 may electrically connect the second driving connection part CD2 connected to the second pixel driver PDC2 to the second cathode EL2_2. In addition, the third conductive pattern CP3 may electrically connect the third driving connection part CD3 connected to the third pixel driver PDC3 and the third cathode EL2_3.

The first conductive pattern CP1 disposed in the first through-hole TH1 may connect the light emitting element and the first pixel driver PDC1, which constitute the first light emitting part EP1, to each other, the second conductive pattern CP2 disposed in the second through-hole TH2 may connect the light emitting element and the second pixel driver PDC2, which constitute the second light emitting part EP2, to each other, and the third conductive pattern CP3 disposed in the third through-hole TH3 may connect the light emitting element and the third pixel driver PDC3, which constitute the third light emitting part EP3, to each other. The conductive pattern will be described below in more detail.

The driving connection part CD (CD1, CD2, CD3) may be a portion connected to the pixel driver PDC. In this example, the driving connection part CD may be connected to one electrode of the transistor constituting the pixel driver PDC. Specifically, the driving connection part CD may be connected to the drain of the sixth transistor T6 illustrated in FIG. 2A or the drain of the first transistor T1 illustrated in FIG. 2B. Thus, the position of the driving connection part CD may correspond to the position of the transistor (see TR in FIG. 5A) that is physically connected to the conductive pattern CP of the pixel driver PDC.

The first to third driving connection parts CD1, CD2, and CD3 may be aligned along the first direction DR1. As described above, the first to third driving connection parts CD1, CD2, and CD3 may correspond to positions of the connection transistors constituting the first to third pixel drivers PDC1, PDC2, and PDC3, respectively. In one pixel, the connection transistor may be a transistor including a connection node to which the pixel driver and the light emitting element are connected. For example, the connection transistor may correspond to the sixth transistor T6 of FIG. 2A or the first transistor T1 of FIG. 2B. Regardless of the shape or size of the light emitting part and the color of light, the shape, position, and arrangement of the pixel drivers PDC (PDC1, PDC2, PDC3) of all the pixels may be simply configured to be designed.

The plurality of through-holes TH may be defined by overlapping the separator SPR. As described above, some of the conductive pattern CP may be disposed in the through-holes TH. The conductive pattern CP disposed in the through-holes TH may be connected to the driving connection part CD.

The through-holes TH may include first to third through-holes TH1, TH2, and TH3. The first to third through-holes TH1, TH2, and TH3 may be defined as non-overlapping the light emitting parts EP1, EP2, and EP3 on the plane (e.g., in a plan view) and as overlapping the separator SPR adjacent to each of the light emitting parts EP1, EP2, and EP3. The first to third through-holes TH1, TH2, and TH3 may be defined as being spaced (e.g., spaced apart) from the edge of the separator SPR to overlap the inside of the separator SPR on the plane (e.g., in a plan view).

In FIGS. 4A and 4B, the first through-hole TH1 and the second through-hole TH2 are illustrated as overlapping the first driving connection part CD1 and the second driving connection part CD2, respectively. However, the first through-hole TH1 and the second through-hole TH2 may be defined at various positions of the conductive pattern CP when overlapping the separator SPR. That is, the arrangement position of the contact part CP-H (see FIG. 5B) of the conductive pattern CP for connection to the pixel driver PDC may be freely selected within a range that overlaps the separator SPR on the plane (e.g., in a plan view). When the first through-hole TH1 and the second through-hole TH2 are defined at positions that do not overlap with the driving connection parts CD1 and CD2, the driving connection parts CD1 and CD2 may extend in the form of a connection line and then may be connected to contact parts CP-H (see FIG. 5B) disposed in the first through-hole TH1 and the second through-hole TH2, respectively. Thus, in the design of the pixel driver PDC, in the arrangement of the contact parts for electrical connection with the light emitting element, restrictions due to the position or shape of the light emitting parts may be reduced to improve the degree of freedom in design.

In FIG. 4B and the like, the third through-hole TH3 is illustrated as being spaced (e.g., spaced apart) from the third driving connection part CD3. The third through-hole TH3 may be defined at various positions when overlapping the separator SPR. In this case, the third driving connection part CD3 may be connected to the third through-hole TH3 in the form of an extending line. However, the position of the third driving connection part CD3 may be designed to overlap the third through-hole TH3 on the plane (e.g., in a plan view), unlike the drawings.

The remaining portion of the conductive pattern CP extending from the first to third through-holes TH1, TH2, and TH3 (an extension part CP-F of the conductive pattern CP to be described later in FIG. 5B) may be illustrated as non-overlapping the light emitting parts EP1, EP2 and EP3 on the plane (e.g., in a plan view). A portion of the extension part CP-F (see FIG. 5B) of the conductive pattern CP may be a portion to which the light emitting element LD (see FIG. 5A) is connected and thus may be provided at a position that does not overlap the light emitting opening OP-PDL (see FIG. 5A).

That is, a portion of the conductive pattern CP connected to each of the cathodes EL2_1, EL2_2, and EL2_3 may be disposed at a position spaced (e.g., spaced apart) from the light emitting opening OP-PDL (see FIG. 5A) at which the entire structure of the light emitting parts EP1, EP2, and EP3 overlap each other. However, the portion of the conductive pattern CP connected to each of the cathodes EL2_1, EL2_2, and EL2_3 may be disposed adjacent to the light emitting parts EP1, EP2, and EP3 and thus the conductive pattern CP may be connected to the cathodes EL2_1, EL2_2, and EL2_3 without separate connection lines or connection pads. The conductive pattern CP and the cathodes EL2_1, EL2_2, and EL2_3 are directly connected to each other without connection lines to electrically connect the light emitting element LD (see FIG. 5A) to the corresponding pixel driver PDC. Thus, there is no need for a space for arranging the separate connection lines or connection pads, and thus, the arrangement area of the light emitting parts EP1, EP2, and EP3 may be expanded on the same surface area of the display area DA, or the number of light emitting parts EP1, EP2, and EP3 may increase to improve resolution of the display device.

Referring again to FIG. 4A, the light emitting parts in the second row Rk+1 may be constituted by the light emitting parts having the shape and arrangement that are axisymmetric with respect to the axis parallel to the first direction DR1 or the second direction DR2. Here, due to the characteristics of the shape and arrangement of the first row light emitting units UT11 and UT12, the second row light emitting units UT21 and UT22 may be substantially constituted by the light emitting parts having a shape in which the first row light emitting units UT11 and UT12 are shifted in the first direction DR1 or the second direction DR2. That is, the second row first column light emitting unit UT21 may be constituted by the light emitting parts having the same shape as the first row second column light emitting unit UT12, and the second row second column light emitting unit UT22 may be constituted by the light emitting parts having the same shape as the first row and first column light emitting unit UT11.

Referring to FIG. 4C, the first electrode EL1 (hereinafter, referred to as an anode) of the light emitting element may be provided in common to the plurality of light emitting parts EP1, EP2, and EP3. That is, the anode EL1 may be provided as a single layer that is integrated with the entire display area DA, and thus, the layer of the anode EL1 may overlap the separator SPR. Alternatively, the anodes EL1 of each of the light emitting elements may be provided to have independent conductive patterns spaced (e.g., spaced apart) from each other and may be electrically connected to each other through another conductive layer. Thus, the patterns of the anode EL1 may be disposed so as not to overlap the separator SPR.

As described above, the first power voltage VDD (see FIG. 2A) may be applied to the anode EL1, and a common voltage may be provided to all of the light emitting parts EP1, EP2, and EP3. The anode EL1 may be connected to the first power line VDL (see FIG. 2A) providing the first power voltage VDD (see FIG. 2A) on the peripheral area NDA or connected to the first power line VDL (see FIG. 2A) on the display area DA.

A plurality of openings OP-EL1 may be defined in the anode EL1, and the openings OP-EL1 may pass through the layer of the anode EL1. The openings of the layer of the anode EL1 may be disposed at a position that does not overlap the light emitting parts EP and may generally be defined at a position overlapping the separator SPR. The openings OP-EL1 may facilitate discharge of a gas generated from an organic layer disposed below the anode EL1, for example, a sixth insulating layer 60 (see FIG. 5A) to be described later. Thus, the gas from the organic layer disposed below the light emitting element may be sufficiently discharged during a process of manufacturing the display panel, and a rate of deterioration of the light emitting element may be reduced due to the reduced gas discharged from the organic layer after the manufacturing.

Because the conductive pattern connecting the light emitting element to the pixel driver is provided, and the through-hole, in which the contact part is disposed, is disposed to overlap the separator, the light emitting element may be easily connected to the pixel driver even if only the shape of the cathode is changed without changing the arrangement or shape of the light emitting elements. In addition, additional contact pads or connection lines for connecting the cathode of the light emitting element to the pixel driver may be excluded to improve design freedom for the arrangement of the pixel driver and expand the surface area of the light emitting part of the display panel or increase in number of light emitting parts, thereby improving the resolution.

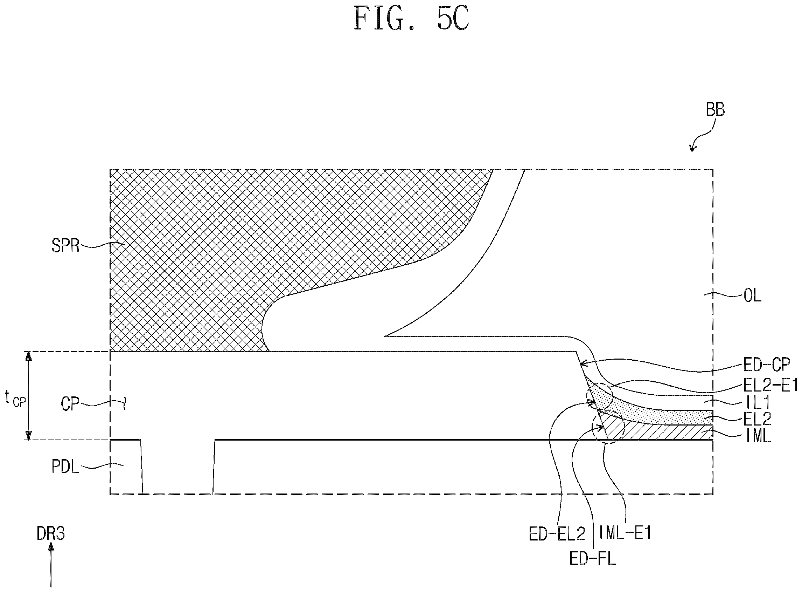

FIG. 5A is a cross-sectional view of the display panel. FIG. 5B is an enlarged cross-sectional view illustrating a partial area of the display panel. FIG. 5C is a cross-sectional view illustrating a partial area of the display panel. FIG. 5A illustrates a cross-sectional view of a portion corresponding to the line I-I' of FIG. 4B. FIG. 5B illustrates an enlarged cross-sectional view of an area AA of FIG. 5A, and FIG. 5C illustrates an enlarged cross-sectional view of an area BB of FIG. 5A. Hereinafter, an example will be described with reference to FIGS. 5A - 5C.

Referring to FIG. 5A, the display panel DP may include a base layer BS, a driving element layer DDL, a light emitting element layer LDL, an encapsulation layer ECL, and a sensing layer ISL. The driving element layer DDL may include a plurality of insulating layers 10, 20, 30, 40, 50, and 60 disposed on the base layer BS, and a plurality of conductive patterns and semiconductor patterns disposed between the insulating layers 10, 20, 30, 40, 50, and 60. The conductive patterns and semiconductor patterns may be disposed between the insulating layers 10, 20, 30, 40, 50, and 60 to constitute the pixel driver PDC. FIG. 5A is a cross-section view illustrating one of the areas on which one light emitting part is disposed for easy explanation.

The base layer BS may be a member providing a base surface on which the pixel driver PDC is disposed. The base layer BS may be a rigid substrate and/or a flexible substrate capable of being bent, folded, and/or rolled. The base layer BS may be a glass substrate, a metal substrate, and/or a polymer substrate. However, the present disclosure is not limited thereto. For example, the base layer BS may be an inorganic layer, an organic layer, and/or a composite layer.

The base layer BS may have a multi-layered structure. For example, the base layer BS may include a first polymer resin layer, a silicon oxide (SiOx) layer disposed on the first polymer resin layer, an amorphous silicon (a-Si) layer disposed on the silicon oxide layer, and/or a second polymer resin layer disposed on the amorphous silicon layer. The silicon oxide layer and the amorphous silicon layer may be referred to as a base barrier layer.

Particularly, the polymer resin layer may include a polyimide-based resin. In addition, the polymer resin layer may include an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and/or a perylene-based resin. In this specification, the "~~-based" resin means as including a functional group of "~~".

Each of the insulating layers, the conductive layers, and the semiconductor layers disposed on the base layer BS may be formed by coating or deposition. Thereafter, the insulating layer, the semiconductor layer, and the conductive layer may be selectively patterned through a plurality of photolithography processes to define a hole in the insulating layer and/or form a semiconductor pattern, a conductive pattern, and/or a signal line.

The driving element layer DDL may include first to sixth insulating layers 10, 20, 30, 40, 50, and 60 that are sequentially laminated on the base layer BS, and a pixel driver PDC. FIG. 5A illustrates one transistor TR and two capacitors C1 and C2 of the pixel driver PDC. The transistor TR may correspond to a transistor connected to the light emitting element LD through the driving connection part CD and the conductive pattern CP, i.e., the connection transistor connected to the node (the fourth node N4 in FIG. 2A or the second node N2 in FIG. 2B) corresponding to the cathode of the light emitting element LD, and may particularly correspond to the sixth transistor T6 of FIG. 2A or the first transistor T1 of FIG. 2B. Other transistors constituting the pixel driver PDC may have the same structure as the transistor TR (hereinafter, referred to as the connection transistor) illustrated in FIG. 5A. However, this is merely an example, and other transistors constituting the pixel driver PDC may have structures different from those of the connection transistor TR. The transistor TR connected to the conductive pattern CP may be an N-type transistor. However, the present disclosure is not limited thereto.

A first insulating layer 10 may be disposed on the base layer BS. The first insulating layer 10 may include an inorganic layer and/or an organic layer and have a single-layered or multilayered structure. The first insulating layer 10 may include aluminum oxide, titanium oxide, silicon oxide, silicon nitride, silicon oxynitride, zirconium oxide, and/or hafnium oxide. The first insulating layer 10 may be a single-layered silicon oxide layer. The insulating layers to be described later may be inorganic layers and/or organic layers and may have a single-layer or multi-layer structure. The inorganic layer may include at least one of the above-described materials, but is not limited thereto.

The first insulating layer 10 may cover a lower conductive layer BCL disposed on the base layer BS. That is, the display panel DP may further include the lower conductive layer BCL disposed to overlap the connection transistor TR in a thickness direction of the base layer BS (e.g., a third directions DR3). The lower conductive layer BCL may block an electric potential due to a polarization phenomenon of the base layer BS from affecting the connection transistor TR. In addition, the lower conductive layer BCL may block light incident from a lower side to the connection transistor TR. At least one of an inorganic barrier layer and/or a buffer layer may be further disposed between the lower conductive layer BCL and the base layer BS.

The lower conductive layer BCL may include a reflective metal. For example, the lower conductive layer BCL may include titanium (Ti), molybdenum (Mo), an alloy containing molybdenum, aluminum (Al), an alloy containing aluminum, aluminum nitride (AIN), tungsten (W), tungsten nitride (WN), and/or copper (Cu).

The lower conductive layer BCL may be connected to a source of the connection transistor TR (or transistor) through a source electrode pattern W1. In this case, the lower conductive layer BCL may be synchronized with the source of the transistor TR. However, this is merely an example, and the lower conductive layer BCL may be connected to and synchronized with the gate of the transistor TR. Alternatively, the lower conductive layer BCL may be connected to another electrode to independently receive a constant voltage or pulse signal. Alternatively, the lower conductive layer BCL may be provided in a shape that is isolated from other conductive patterns. The lower conductive layer BCL may be provided in various shapes.

The transistor TR may be disposed on the first insulating layer 10. The connection transistor TR may include a semiconductor pattern SP and a gate electrode GE. The semiconductor pattern SP may be disposed on the first insulating layer 10 overlapping the lower conductive layer BCL in the third direction DR3. The semiconductor pattern SP may include an oxide semiconductor. However, the oxide semiconductor may include transparent conductive oxide (TCO) such as indium tin oxide (ITO), indium zinc oxide (IZO), indium gallium zinc oxide (IGZO), zinc oxide (ZnO), and/or indium oxide (In2O3). However, the present disclosure is not limited thereto. For example, the semiconductor pattern SP may include amorphous silicon, low-temperature polycrystalline silicon, and/or polycrystalline silicon.

The semiconductor pattern SP may include a source region SR, a drain region DR, and a channel region CR, which are classified according to a degree of conductivity. The channel region CR may be a portion overlapping the gate electrode GE on the plane (e.g., in a plan view). For example, the channel region CR may be a portion overlapping the gate electrode GE in the third direction DR3. The source region SR and the drain region DR may be spaced (e.g., spaced apart) with the channel region CR therebetween. When the semiconductor pattern SP is the oxide semiconductor, each of the source region SR and the drain region DR may be a reduced area. Thus, each of the source region SR and the drain region DR have a relatively high reduction metal content when compared to the channel region CR. Alternatively, when the semiconductor pattern SP is made of polycrystalline silicon, each of the source region SR and the drain region DR may be an area doped at a high concentration.

The source region SR and the drain region DR may have conductivity relatively higher than that of the channel region CR. The source region SR may correspond to a source electrode of the connection transistor TR, and the drain region DR may correspond to a drain electrode of the connection transistor TR. As illustrated in FIG. 5A, separate source electrode patterns W1 and drain electrode patterns W2 respectively connected to the source region SR and the drain region DR may be further provided. Specifically, each of the separate source electrode pattern W1 and drain electrode pattern W2 may be integrally formed with one of the lines constituting the pixel driver (see PDC in FIG. 2A or PDC-1 in FIG. 2B).

The second insulating layer 20 overlaps the plurality of pixels in common and may cover the semiconductor pattern SP and the first insulating layer 10. The second insulating layer 20 may be an inorganic layer and/or an organic layer and have a single-layered or multilayered structure. The second insulating layer 20 may include aluminum oxide, titanium oxide, silicon oxide, silicon nitride, silicon oxynitride, zirconium oxide, and/or hafnium oxide. In this example, the second insulating layer 20 may include a single-layered silicon oxide layer.

The gate electrode GE may be disposed on the second insulating layer 20. The gate electrode GE may correspond to the gate of the connection transistor TR. In addition, the gate electrode GE may be disposed above the semiconductor pattern SP overlapping the semiconductor pattern SP in the third direction DR3. However, this is merely an example, and the gate electrode GE may be disposed below the semiconductor pattern SP.

The gate electrode GE may include titanium (Ti), silver (Ag), molybdenum (Mo), aluminum (Al), aluminum nitride (AIN), tungsten (W), tungsten nitride (WN), copper (Cu), and/or alloys thereof, but is not particularly limited thereto.

A third insulating layer 30 may be disposed on the gate electrode GE and the second insulating layer 20. The third insulating layer 30 may be an inorganic layer and/or an organic layer and have a single-layered or multilayered structure. The third insulating layer 30 and may include aluminum oxide, titanium oxide, silicon oxide, silicon nitride, silicon oxynitride, zirconium oxide, and/or hafnium oxide.

A first capacitor electrode CPE1 and the second capacitor electrode CPE2 from among the plurality of conductive patterns W1, W2, CPE1, CPE2, and CPE3 may constitute the first capacitor C1. The first capacitor electrode CPE1 and the second capacitor electrode CPE2 may be spaced (e.g., spaced apart) from each other with the first insulating layer 10 and the second insulating layer 20 therebetween. The first capacitor electrode CPE1 and the second capacitor electrode CPE2 may overlap each other in the third direction DR3.

The first capacitor electrode CPE1 and the lower conductive layer BCL may have an integrated shape. Also, the second capacitor electrode CPE2 and the gate electrode GE may have an integrated shape.

A third capacitor electrode CPE3 may be disposed on the third insulating layer 30. The third capacitor electrode CPE3 may be spaced (e.g., spaced apart) from the second capacitor electrode CPE2 with the third insulating layer 30 therebetween and may overlap each other on the plane (e.g., in a plan view). For example, the third capacitor electrode CPE3 may overlap the second capacitor electrode CPE2 in the third direction DR3. The third capacitor electrode CPE3 and the second capacitor electrode CPE2 may constitute the second capacitor C2.

A fourth insulating layer 40 may be disposed on the third insulating layer 30 and/or the third capacitor electrode CPE3. The fourth insulating layer 40 may be an inorganic layer and/or an organic layer and have a single-layered or multilayered structure. The fourth insulating layer 40 may include aluminum oxide, titanium oxide, silicon oxide, silicon nitride, silicon oxynitride, zirconium oxide, and/or hafnium oxide.

A source electrode pattern W1 and a drain electrode pattern W2 may be disposed on the fourth insulating layer 40. The source electrode pattern W1 may be connected to the source region SR of the connection transistor TR through the first contact hole CNT1, and the source electrode pattern W1 and the source region SR of the semiconductor pattern SP may function as a source of the connection transistor TR. The drain electrode pattern W2 may be connected to the drain region DR of the connection transistor TR through the second contact hole CNT2, and the drain electrode pattern W2 and the drain region DR of the and the semiconductor pattern SP may function as a drain of the connection transistor TR. The first contact hole CNT1 and the second contact hole CNT2 may penetrate through the second insulating layer 20, the third insulating layer 30, and the fourth insulating layer 40. A fifth insulating layer 50 may be disposed on the source electrode pattern W1 and the drain electrode pattern W2, and the fourth insulating layer 40. A contact hole 50-H may be defined in the fifth insulating layer 50. In this specification, the fifth insulating layer 50 may also be referred to as a lower insulating layer, and a contact hole 50-H defined in the fifth insulating layer 50 may be referred to as a lower hole.

The driving connection part CD may be disposed on the fifth insulating layer 50. The driving connection part CD may be disposed to be filled into the contact hole 50-H defined in the fifth insulating layer 50. The pixel driver PDC and the light emitting element LD may be electrically connected to each other through the driving connection part CD and the conductive pattern CP disposed on the driving connection part CD. That is, the driving connection part CD may be included as a portion that electrically connects the connection transistor TR to the light emitting element LD. The driving connection part CD may be a connection node connecting the pixel driver PDC to the light emitting element LD connected through the conductive pattern CP. That is, the driving connection part CD may correspond to the fourth node N4 illustrated in FIG. 2A or the second node N2 illustrated in FIG. 2B. This is merely an example, and if the driving connection part CD is connected to the light emitting element LD, a connection line may be defined as the connection node with various elements from among the elements constituting the pixel driver PDC according to the design of the pixel driver PDC.

The driving connection part CD may have a three-layered structure. In detail, the driving connection part CD may include a first layer L1, a second layer L2, and a third layer L3, which are sequentially laminated along the third direction DR3. The second layer L2 may include a material different from that of the first layer L1. Also, the second layer L2 may include a material different from that of the third layer L3. The second layer L2 may have a relatively greater thickness when compared to the first layer L1. In addition, the second layer L2 may have a relatively greater thickness when compared to the third layer L3. The second layer L2 may include a highly conductive material. The second layer L2 may include aluminum (Al).

The first layer L1 may include a material having a lower etch rate than the second layer L2. That is, the second layer L2 may be made of a material with high etch selectivity with respect to the first layer L1. Also, the third layer L3 may include a material having a lower etch rate than the second layer L2. That is, the second layer L2 may be made of a material with high etch selectivity with respect to the third layer L3. For example, the first layer L1 and the third layer L3 may include titanium (Ti), and the second layer L2 may include aluminum (Al). However, the present disclosure is not limited thereto, and the driving connection part CD may have a single-layered structure or a laminated structure different from the above-described combination.

In FIG. 5A, etc., the entire driving connection part CD is illustrated as being disposed to overlap a lower side of the separator SPR. However, the present disclosure is not limited thereto. When the pixel driver PDC, etc., is arranged to be spaced (e.g., spaced apart) from the corresponding light emitting part EP without overlapping the separator SPR as illustrated in FIG. 5A, etc., the driving connection part CD may be disposed in an extending shape on the fifth insulating layer 50. In this case, a portion of the driving connection part CD disposed on the fifth insulating layer 50 may not overlap the separator SPR.

The sixth insulating layer 60 may be disposed on the fifth insulating layer 50 and the driving connection part CD. The sixth insulating layer 60 may be disposed to cover the driving connection part CD. In this specification, the sixth insulating layer 60 may also be referred to as an upper insulating layer. Each of the fifth insulating layer 50 and the sixth insulating layer 60 may be an organic layer. For example, each of the fifth insulating layer 50 and the sixth insulating layer 60 may include general-purpose polymers such as benzocyclobutene (BCB), polyimide, hexamethyldisiloxane (HMDSO), polymethylmethacrylate (PMMA), and/or polystyrene (PS), a polymer derivative having a phenolic group, an acrylic polymer, an imide polymer, an aryl ether polymer, an amide polymer, a fluorine polymer, a p-xylene polymer, a vinyl alcohol polymer, and/or a blend thereof.

A through-hole 60-H (see FIG. 5B) may be defined in the sixth insulating layer 60. The through-hole 60-H defined in the sixth insulating layer 60 may correspond to a portion of the above-described through-hole TH: TH1, TH2, TH3 (FIG. 4A, etc.). The through-hole 60-H defined in the sixth insulating layer 60 may be called a lower through-hole. The lower through-hole 60-H may be defined by overlapping the separator SPR in the third direction DR3. For example, the lower through-hole 60-H may entirely overlap the separator SPR in the third direction DR3.

In addition, the lower through-hole 60-H may be defined in an upper portion of the driving connection part CD by overlapping the driving connection part CD. The lower through-hole 60-H defined in the sixth insulating layer 60 may be a portion at which a portion of the conductive pattern CP is disposed. The lower through-hole 60-H may be defined to be integrated with the through-hole PDL-H (see FIG. 5B) defined in the pixel defining layer PDL, which will be described later. The lower through-hole 60-H and the through-hole PDL-H (see FIG. 5B) defined in the pixel defining layer PDL may be integrated to define a through-hole TH. The conductive pattern CP may be connected to the driving connection part CD through the through-hole TH.

A light emitting element layer LDL may be disposed on the sixth insulating layer 60. The light emitting element layer LDL may include a pixel defining layer PDL, a light emitting element LD, and a separator SPR. For the pixel defining layer PDL may be an organic layer. For example, the pixel defining layer PDL may include general-purpose polymers such as benzocyclobutene (BCB), polyimide, hexamethyldisiloxane (HMDSO), polymethylmethacrylate (PMMA), and/or polystyrene (PS), a polymer derivative having a phenolic group, an acrylic polymer, an imide polymer, an aryl ether polymer, an amide polymer, a fluorine polymer, a p-xylene polymer, a vinyl alcohol polymer, and/or a blend thereof.

The pixel defining layer PDL may have a property of absorbing light and may have, for example, a black color. That is, the pixel defining layer PDL may include a black coloring agent. A black component may include a black dye and/or a black pigment. The black component may include carbon black, a metal such as chromium, and/or oxide thereof. The pixel defining layer PDL may correspond to a light blocking pattern having light blocking properties.

An opening OP-PDL (hereinafter, a light emitting opening) exposing at least a portion of the first electrode EL1 to be described later may be defined in the pixel defining layer PDL. The light emitting opening OP-PDL may be provided in plurality that are arranged to correspond for each light emitting element. In the light emitting opening OP-PDL, all components of the light emitting element LD may be disposed to overlap each other and may be an area on which light emitted by the light emitting element LD is substantially displayed. Thus, the shape of the light emitting part EP illustrated in FIG. 4A may substantially correspond to the shape of the light emitting opening OP-PDL on the plane (e.g., in a plan view).

The through-hole PDL-H may be defined in the pixel defining layer PDL (see FIG. 5B). The through-hole defined in the pixel defining layer PDL may be called an upper through-hole PDL-H. The upper through-hole PDL-H may be defined to not overlap the light emitting opening OP-PDL. The upper through-hole PDL-H may be defined to overlap the lower through-hole 60-H of the sixth insulating layer 60 described above. The lower through-hole 60-H and the upper through-hole PDL-H may be defined integrally to define the through-hole TH. A portion of the conductive pattern CP may be filled in the through-hole TH. The upper through-hole PDL-H may overlap the separator SPR.

The light emitting element layer LDL may include a light emitting element LD, and the light emitting element LD may include a first electrode EL1, an intermediate layer IML, and a second electrode EL2. The first electrode EL1 may be a semi-transmissive, transmissive, and/or reflective electrode. The first electrode EL1 may include a reflective layer made of silver (Ag), magnesium (Mg), aluminum (Al), platinum (Pt), palladium (Pd), gold (Au), nickel (Ni), neodymium (Nd), iridium (Ir), chromium (Cr), and/or a compound thereof, and a transparent and/or translucent electrode layer disposed on the reflective layer. The transparent and/or translucent electrode layer may include at least one or more selected from the group consisting of indium tin oxide (ITO), indium zinc oxide (IZO), indium gallium zinc oxide (IGZO), zinc oxide (ZnO), and/or indium oxide (In₂O₃), and/or aluminum doped zinc oxide (AZO). For example, the first electrode EL1 may include a laminated structure of ITO/Ag/ITO.

The first electrode EL1 may be an anode of the light emitting element LD. That is, the first electrode EL1 may be connected to the first power line VDL (see FIG. 2A), and the first power voltage VDD (see FIG. 2A) may be applied. The first electrode EL1 may be connected to the first power line VDL on the display area DA (see FIG. 3A or 3B) or connected to the first power line VDL on the peripheral area NDA (see FIG. 3A or 3B). In the latter case, the first power line VDL may be disposed on the peripheral area NDA (see FIG. 3A or 3B), and the first electrode EL1 may have a shape extending to the peripheral area NDA (see FIG. 3A or 3B).

In the cross-sectional view of FIG. 5A, the first electrode EL1 may overlap the light emitting opening OP-PDL and do not overlap the separator SPR, but as described above with reference to FIG. 4C, the first electrodes EL1 of the light emitting elements may have an integrated shape and have a mesh or lattice shape in which openings OP-EL1 are defined in some areas. That is, if the same first power voltage VDD is applied to the first electrode EL1 of each of the plurality of light emitting elements, the shape of the first electrode EL1 may be provided in various manners.

The intermediate layer IML may be disposed between the first electrode EL1 and the second electrode EL2. The first electrode EL1, the intermediate layer IML, and the second electrode EL2 may be sequentially laminated in the third direction DR3. The intermediate layer IML may include a emission layer EML and a functional layer FNL. The light emitting element LD may include an intermediate layer IML having various structures. For example, the functional layer FNL may be provided as a plurality of layers or as two or more layers spaced (e.g., spaced apart) from each other with the emission layer EML therebetween. Alternatively, the functional layer FNL may be omitted.

The emission layer EML may include an organic light emitting material. In addition, the emission layer EML may include an inorganic light emitting material or may be provided as a mixed layer of an organic light emitting material and an inorganic light emitting material. In this example, the emission layers EML provided in each adjacent light emitting part EP may include light emitting materials displaying different colors. For example, the emission layer EML provided in each light emitting part EP may provide one of blue, red, and/or green light. However, the present disclosure is not limited thereto, and the emission layer EML disposed on all the light emitting parts EP may include a light emitting material displaying the same color. In this case, the emission layer EML may provide blue light or white light. In addition, in FIG. 5A, the emission layer EML and the functional layer FNL are illustrated in different shapes, but are not limited thereto, and the emission layer EML and the functional layer FNL may be disposed in the same shape on the plane (e.g., in a plan view).

The functional layer FNL may be disposed between the first electrode EL1 and the second electrode EL2. Specifically, the functional layer FNL may be disposed between the first electrode EL1 and the emission layer EML or between the second electrode EL2 and the emission layer EML. Alternatively, the functional layer FNL may be disposed between the first electrode EL1 and the emission layer EML and between the second electrode EL2 and the emission layer EML. In this example, the emission layer EML is illustrated as being inserted into the functional layer FNL. However, this is merely an example, and the functional layer FNL may include a layer disposed between the emission layer EML and the first electrode EL1 and/or a layer disposed between the emission layer EML and the second electrode EL2 and may be provided in plurality.

The functional layer FNL may control the movement of charges between the first electrode EL1 and the second electrode EL2. The functional layer FNL may include a hole injection/transport material and/or an electron injection/transport material. The functional layer FNL may include an electron blocking layer, a hole transporting layer, a hole injection layer, a hole blocking layer, an electron transporting layer, an electron injection layer, and/or a charge generating layer.

The functional layer FNL may also be disposed on the pixel defining layer PDL. The functional layer FNL may be disposed to extend from the light emitting opening OP-PDL onto the pixel defining layer PDL so as to be connected to one side of the conductive pattern CP.

The second electrode EL2 may be disposed on the intermediate layer IML. The second electrode EL2 may be disposed on the functional layer FNL extending onto the pixel defining layer PDL. As described above, the second electrode EL2 may be connected to the conductive pattern CP and electrically connected to the pixel driver PDC. That is, the second electrode EL2 may be electrically connected to the transistor TR through the conductive pattern CP and the driving connection part CD.

The display panel DP may include the separator SPR. The separator SPR may be included in the light emitting element layer LDL. The separator SPR may be disposed on the pixel defining layer PDL. The second electrode EL2 and the intermediate layer IML may be provided to be commonly deposited on the plurality of pixels through an open mask. Here, the second electrode EL2 and the intermediate layer IML may be divided by the separator SPR. As described above, the separator SPR may have a closed line shape for each light emitting part, and thus the second electrode EL2 and the intermediate layer IML may have a divided shape for each light emitting part. That is, the second electrode EL2 and the intermediate layer IML may be electrically independent for each adjacent pixel. Additionally, the conductive pattern CP may be disposed between the separator SPR and the pixel defining layer PDL, and as illustrated in FIGS. 4A and 4B, each of the conductive patterns CP may be disposed to overlap the separator SPR along the separator SPR that separates the light emitting parts. In addition, each of the first to third conductive patterns CP1, CP2, and CP3 may have a shape that is separated to be around (e.g., to surround) the light emitting parts EP1, EP2, and EP3, respectively.

The separator SPR will be described in more detail with reference to FIGS. 5A to 5C. Referring to FIGS. 5A and 5B, a width of a top surface of the separator SPR may be greater than a width of a bottom surface thereof. The separator SPR may include a portion of which a width in the cross-section gradually increases in the third direction DR3, which is a thickness direction (e.g., the third direction DR3). For example, the separator SPR may have an inverted taper shape.

The separator SPR may have a double inverted taper shape. Referring to FIG. 5B and the like, a taper angle defined by a first side surface TP1 and a second side surface TP2 of the separator SPR with respect to a top surface of the pixel defining layer PDL may be different from each other. The taper angle defined by each of the first side surface TP1 and the second side surface TP2 may be an obtuse angle. For example, the taper angle defined by the first side surface TP1 with respect to the top surface of the pixel defining layer PDL may be less than the taper angle defined by the second side surface TP2 with respect to the top surface of the pixel defining layer PDL. However, the present disclosure is not limited thereto.

In addition, the first side surface TP1 and the second side surface TP2 may be provided to have different curvatures. At least one inflection portion may be included between the first side surface TP1 and the second side surface TP2. The shape of each of the first side surface TP1 and the second side surface TP2 are not limited thereto, and the taper angle or curvature of each of the first side surface TP1 and the second side surface TP2 may be modified in various manners.

The separator SPR may include a lower pattern SPR-B adjacent to the pixel defining layer PDL and an upper pattern SPR-T disposed on the lower pattern SPR-B. The upper pattern SPR-T may be continuously disposed on the lower pattern SPR-B. The upper pattern SPR-T and the lower pattern SPR-B may be integrated with each other. Here, side surfaces of the lower pattern SPR-B and the upper pattern SPR-T may be provided to have different curvatures. For example, an inflection portion may be included between the lower pattern SPR-B and the upper pattern SPR-T. However, this is merely an example, and if the separator SPR electrically disconnects the second electrode EL2 for each pixel, the shape may be set in various manners. The separator SPR may include an insulating material and particularly may include an organic insulating material. The separator SPR may include an inorganic insulating material, provided as a multi-layer structure of an organic insulating material and an inorganic insulating material, and include a conductive material. The separator SPR may be a division structure that separates the light emitting parts EP and may disconnect the second electrodes EL2 of neighboring light emitting parts EP from each other. That is, as long as the second electrode EL2 is electrically disconnected for each pixel, the type of the material of the separator SPR is not particularly limited.

The conductive pattern CP may be disposed at a lower side of the separator SPR. The conductive pattern CP may include a contact part CP-H and an extension part CP-F. The extension part CP-F may have a substantially flat top surface. In addition, the extension part CP-F may have some irregular uneven surfaces within a tolerance range allowed in the process. Depending on the manufacturing process of the conductive pattern CP or the progress of the processes of other layers manufactured after forming the conductive pattern CP, the extension part CP-F may include some portions that are not flat. For example, the top surface of the extension part CP-F may include roughness.

The conductive pattern CP may include a transparent conductive metal material. However, the conductive pattern CP may include transparent conductive oxide (TCO) such as indium tin oxide (ITO), indium zinc oxide (IZO), indium gallium zinc oxide (IGZO), zinc oxide (ZnO), and/or indium oxide (In2O3).

The contact part CP-H may be a portion of the conductive pattern CP that is connected to the pixel driver PDC and may be a portion that is substantially connected to the connection transistor TR. The contact part CP-H of the conductive pattern CP may pass through the pixel defining layer PDL and the sixth insulating layer 60 so as to be connected to a drain region DR of the semiconductor pattern SP through the driving connection part CD and a drain electrode pattern W2.

The extension part CP-F of the conductive pattern CP may be a portion connected to the light emitting element LD. The extension part CP-F may be a portion disposed on the top surface of the pixel defining layer PDL. The extension part CP-F may be disposed below the separator SPR. The conductive pattern CP may include an exposed portion that is not covered by the separator SPR. The second electrode EL2 may be connected to the exposed conductive pattern extension part CP-F. That is, the second electrode EL2 of the light emitting element LD may be directly contacted to an exposed end of the conductive pattern extension CP-F.

Referring to FIGS. 5A and 5B, the contact part CP-H may be disposed to be filled into the through-hole TH, and the extension part CP-F may extend from the contact part CP-H and may be disposed on the pixel defining layer PDL. That is, the conductive pattern CP may include the contact part CP-H including one end filled in the through-hole TH and the extension part CP-F including the other end connected to the second electrode EL2 and connected to the contact part CP-H.

The contact part CP-H may entirely overlap the separator SPR. The extension part CP-F may be disposed below the separator SPR. The extension part CP-F may be disposed to overlap the separator SPR. One edge of the extension part CP-F may be covered by the separator SPR, and the other edge of the extension part CP-F may not be covered by the separator SPR and may be exposed on the pixel defining layer PDL.

Referring to FIGS. 5A - 5C, one edge EL-CP of the extension part CP-F exposed on the pixel defining layer PDL may not overlap the separator SPR on the plane (e.g., in a plan view) and may be disposed to protrude toward the light emitting part EP. However, this is merely an example, and the present disclosure is not limited thereto. For example, one edge EL-CP of the extension part CP-F exposed on the pixel defining layer PDL may overlap the edge EL-SP of the separator SPR on the plane (e.g., in a plan view) or may be spaced (e.g., spaced apart) from the edge EL-SP to overlap the separator SPR on the plane (e.g., in a plan view).

Referring to FIG. 5C, the second electrode EL2 (hereinafter, referred to as a cathode) may be connected to the exposed end of the conductive pattern CP. The cathode EL2 may be connected to one exposed side ED-CP of the conductive pattern CP. One side ED-EL2 of the cathode EL2 may be connected to the exposed side ED-CP of the conductive pattern CP. That is, the cathode EL2 of the light emitting element LD may be connected to one side ED-CP of the conductive pattern CP in the form of a sidewall contact.

As illustrated in FIGS. 5A and 5B, the thickness t_{CP} of the conductive pattern CP may be about 1,000 Å (100nm) or more and about 5,000 A (500nm) or less. That is, the thickness t_{CP} of the extension part CP-F of the conductive pattern CP may be about 1,000 Å (100nm) or more and about 5,000 A (500nm) or less. As the conductive pattern CP is provided to have a thickness of about 1,000 Å (100nm) or more, a sufficient sidewall contact area of the cathode EL2 may be secured to ensure good electrical connection quality of the cathode EL2. In addition, an increase in thickness of the light emitting element layer LDL may be reduced or minimized by setting the thickness t_{CP} of the conductive pattern CP to about 5,000 A (500nm) or less.

In addition, the intermediate layer IML may be connected to one side surface ED-CP of the conductive pattern CP. One side surface ED-FL of the intermediate layer IML may be connected to the exposed side surface ED-CP of the conductive pattern CP. The cathode EL2 may be disposed on the intermediate layer IML connected to the conductive pattern CP while being connected to one side surface ED-CP of the conductive pattern CP. The cathode EL2 may be disposed while covering the intermediate layer IML. The intermediate layer IML connected to one side surface ED-CP of the conductive pattern CP may be at least a portion of the functional layer FNL. The cathode EL2, the exposed top surface of the conductive pattern CP, the separator SPR, etc. may be covered by the encapsulation layer ECL. Referring to FIGS. 5A and 5C, the cathode EL2 and the intermediate layer IML constituting the light emitting element LD may be disconnected by the separator SPR. A first end IML-E1 of the disconnected intermediate layer IML may be connected to one side surface ED-CP of the conductive pattern CP on the pixel defining layer PDL, and the first end IML-E1 and the second end IML-E2 of the disconnected intermediate layer IML may be disposed on the separator SPR.

In addition, the first end EL2-E1 of the disconnected cathode EL2 may be connected to one side surface ED-CP of the conductive pattern CP on the first end IML-E1 of the intermediate layer IML, and the first end EL2-E1 and the second end EL2-E2 of the disconnected cathode EL2 may be disposed on the separator SPR. The second end EL2-E2 of the cathode EL2 may cover the second end IML-E2 of the intermediate layer IML. That is, the first portion including the first end IML-E1 of the disconnected intermediate layer IML and the first end EL2-E1 of the cathode EL2 may be connected to one end of the conductive pattern CP, and the second portion including the second end IML-E2 of the disconnected intermediate layer IML and the second end EL2-E2 of the cathode EL2 may be disposed on the separator SPR.

As illustrated in FIGS. 5A - 5C, the first end IML-E1 of the disconnected intermediate layer IML and the first end EL2-E1 of the cathode EL2 may not overlap the separator SPR on the plane (e.g., in a plan view). That is, one side surface ED-EL2 of the cathode EL2 and one side surface ED-FL of the intermediate layer IML, which are connected in the form of the sidewall contact, on the exposed one side surface ED-CP of the conductive pattern CP may not overlap the separator SPR on the plane (e.g., in a plan view).

A portion of the cathode EL2 and a portion of the intermediate layer IML that are disconnected and disposed above the separator SPR may be referred to as a dummy layer UP. The dummy layer UP may be disposed above the separator SPR. The dummy layer UP may include a first dummy layer UP1 disposed on the separator SPR and a second dummy layer UP2 disposed on the first dummy layer UP1. The first dummy layer UP1 may be provided through the same process as the intermediate layer IML and may include the same material. The second dummy layer UP2 may be provided through the same process as the cathode EL2 and may include the same material. That is, the first dummy layer UP1 and the second dummy layer UP2 may be provided concurrently (e.g., simultaneously) during the formation of the intermediate layer IML and the cathode EL2. In other implementations, the display panel DP may not include the dummy layer UP.

Referring to FIGS. 5A and 5B, the first ends EL2-E1 and IML-E1 of the cathode EL2 and the intermediate layer IML may be spaced (e.g., spaced apart) from the separator SPR and disposed on the pixel defining layer PDL, and the second ends EL2-E2 and IML-E2 of the cathode EL2 and the intermediate layer IML may be separated from the first ends EL2-E1 and IML-E1 and may be disposed on the side surface of the separator SPR. Even if the first ends EL2-E1 and IML-E1 and the second ends EL2-E2 and IML-E2 are connected without being distinguished from each other, when a thickness of the portion disposed along the side surface of the separator SPR is thin so that electrical resistance is high, if the cathode EL2 between the adjacent pixels is electrically disconnected, it is assumed that the cathode EL2 is divided by the separator SPR.

Even if there is no separate patterning process for the cathode EL2 and/or the intermediate layer IML, the cathode EL2 or the intermediate layer IML may not be provided on the side surface of the separator SPR or may be provided to be thin, and thus, the cathode EL2 or the intermediate layer IML may be divided for each pixel. In addition, if the cathode EL2 or the intermediate layer IML are electrically disconnected between the adjacent pixels, the shape of the separator SPR may be modified in various manners.

Referring again to FIG. 5A, the encapsulation layer ECL may be disposed on the light emitting element layer LDL. The encapsulation layer ECL may cover the light emitting element LD to cover the separator SPR. The encapsulation layer ECL may include a first inorganic layer IL1, an organic layer OL, and a second inorganic layer IL2, which are sequentially laminated. However, the present disclosure is not limited thereto. For example, the encapsulation layer ECL may further include a plurality of inorganic layers and organic layers. In addition, the encapsulation layer ECL may be a glass substrate.

The first and second inorganic layers IL1 and IL2 may protect the light emitting element LD from moisture and/or oxygen outside the display panel DP, and the organic layer OL may protect the light emitting element LD from foreign substances such as particles remaining in the process of forming the first inorganic layer IL1. Each of the first and second inorganic layers IL1 and IL2 may include a silicon nitride layer, a silicon oxynitride layer, a silicon oxide layer, a titanium oxide layer, an aluminum oxide layer, and/or the like. The organic layer OL may include an acryl-based organic layer, and the type of material is not limited.

The sensing layer ISL may sense an external input. The sensing layer ISL may be disposed on the encapsulation layer ECL through a continuous process. In this case, it may be expressed that the sensing layer ISL is directly disposed on the encapsulation layer ECL. The direct disposition may mean that no other components are disposed between the sensing layer ISL and the encapsulation layer ECL. That is, a separate adhesive member may not be disposed between the sensing layer ISL and the encapsulation layer ECL. However, this is merely an example, and in the display panel DP, the sensing layer ISL may be separately provided and then coupled to the display panel DP through an adhesive member.

The sensing layer ISL may include a plurality of conductive layers and a plurality of insulating layers. The plurality of conductive layers may include a first sensing conductive layer MTL1 and a second sensing conductive layer MTL2, and the plurality of insulating layers may include first to third sensing insulating layers 71, 72, and 73. However, this is merely an example, and the number of conductive layers and insulating layers is not limited.

The first to third sensing insulating layers 71, 72, and 73 may have a single-layered structure or a multi-layered structure in which a plurality of layers are laminated in the third direction DR3. Each of the first to third sensing insulating layers 71, 72, and 73 may include an inorganic layer. The inorganic layer may include aluminum oxide, titanium oxide, silicon oxide, silicon nitride, silicon oxynitride, zirconium oxide, and/or hafnium oxide. Each of the first to third sensing insulating layers 71, 72, and 73 may include an organic layer. The organic layer may include an acrylic-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and/or a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be connected to the first sensing conductive layer MTL1 through a contact hole CNT defined in the second sensing insulating layer 72. Each of the first sensing conductive layer MTL1 and the second sensing conductive layer MTL2 may have a single-layer structure or a multi-layer structure laminated along the third direction DR3.

The single-layered sensing conductive layer may include a metal layer and/or a transparent conductive layer. The metal layer may include molybdenum, silver, titanium, copper, aluminum, and/or an alloy thereof. The transparent conductive layer may include transparent conductive oxide such as indium tin oxide (ITO), indium zinc oxide (IZO), zinc oxide (ZnO), and/or indium zinc tin oxide (IZTO). Alternatively, the transparent conductive layer may include a conductive polymer such as PEDOT, a metal nanoline, graphene, and/or the like.

The multi-layered sensing conductive layer may include metal layers. The metal layers may have, for example, a three-layered structure of titanium (Ti)/aluminum (Al)/titanium (Ti). Alternatively, the sensing conductive layer having the multilayered structure may include at least one metal layer and at least one transparent conductive layer.

The first sensing conductive layer MTL1 and the second sensing conductive layer MTL2 may constitute a sensor that senses an external input in the sensing layer ISL. The sensor may be driven by a capacitance method and may be driven by one of a mutual-cap method and/or a self-capacitance method. However, this is merely an example, and the sensor may be driven by a resistive film method, an ultrasonic method, and/or an infrared method in addition to the capacitance method.

Each of the first sensing conductive layer MTL1 and the second sensing conductive layer MTL2 may include a transparent conductive oxide and/or may have a metal mesh shape made of an opaque conductive material. The first sensing conductive layer MTL1 and the second sensing conductive layer MTL2 may have various materials and various shapes as long as visibility of an image displayed by the display panel DP is not deteriorated.

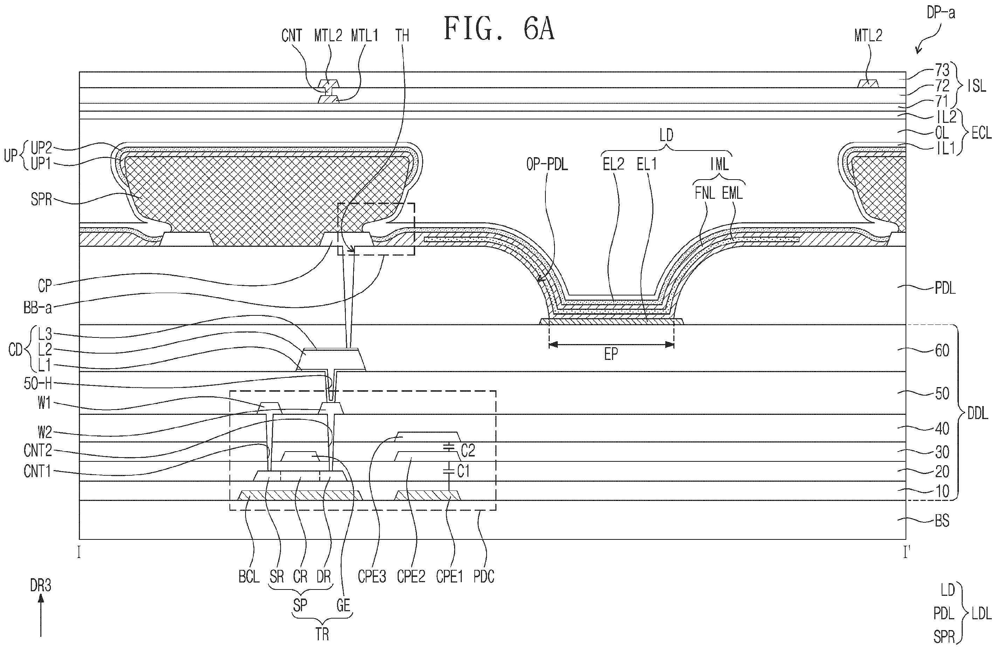

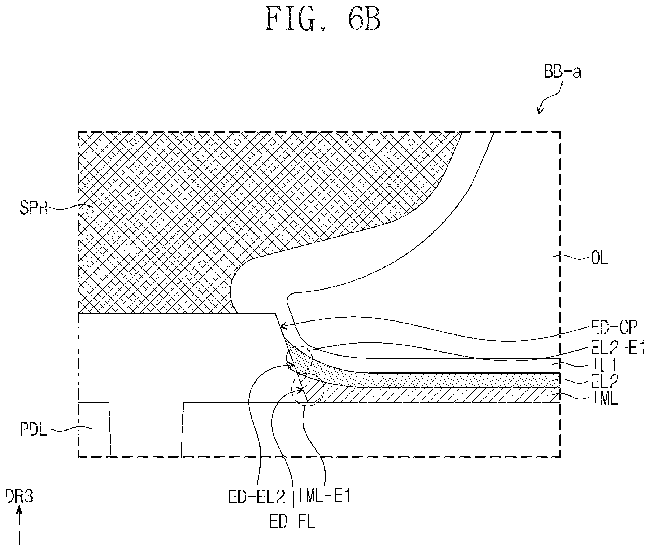

FIG. 6A is a cross-sectional view of a display panel. FIG. 6B is a cross-sectional view illustrating a portion of an area of the display panel. FIG. 6A illustrates a cross-sectional view of a portion corresponding to that in FIG. 5A, taken I-I' line of FIG. 4B. FIG. 6B illustrates an enlarged cross-sectional view of an area BB-a of FIG. 6A.

A display panel DP-a illustrated in FIGS. 6A and 6B may be the same as the display panel DP illustrated in FIGS. 5A - 5C except for a connection position of a conductive pattern CP and a second electrode EL2 (hereinafter referred to as a cathode).

In the display panel DP-a illustrated in FIGS. 6A and 6B, the cathode EL2 of a light emitting element LD may be connected to one side ED-CP of a conductive pattern CP in the form of a sidewall contact. In addition, the intermediate layer IML may be connected to one side surface ED-CP of the conductive pattern CP. One side surface ED-FL of the intermediate layer IML may be connected to the exposed side surface ED-CP of the conductive pattern CP.

The cathode EL2 may be disposed on the intermediate layer IML connected to the conductive pattern CP while being connected to one side surface ED-CP of the conductive pattern CP. The cathode EL2 may be disposed while covering the intermediate layer IML.

The contact part CP-H may entirely overlap the separator SPR. The extension part CP-F may be disposed below the separator SPR. One edge of the extension part CP-F may be covered by the separator SPR, and the other edge of the extension part CP-F may not be covered by the separator SPR and may be exposed on the pixel defining layer PDL. Unlike the example illustrated in FIGS. 5A - 5C, in the example illustrated in FIGS. 6A and 6B, one edge EL-CP of the extension part CP-F exposed on the pixel defining layer PDL may overlap the separator SPR on the plane (e.g., in a plan view).

As illustrated in FIGS. 6A and 6B, a first end IML-E1 of a disconnected intermediate layer IML and a first end EL2-E1 of a cathode EL2 may overlap the separator SPR on the plane (e.g., in a plan view). That is, one side surface ED-EL2 of the cathode EL2 and one side surface ED-FL of the intermediate layer IML, which are connected in the form of the sidewall contact, on the exposed one side surface ED-CP of the conductive pattern CP may overlap the separator SPR on the plane (e.g., in a plan view).

As described above, the display device includes the conductive pattern CP disposed below the separator SPR. The conductive pattern CP may be disposed between the cathode EL2 and the driving connection part CD to electrically connect the light emitting element LD to the pixel driver PDC. That is, the conductive pattern CP may be directly connected to each of the cathode EL2 and the driving connection part CD, and thus, a separate connection line or connection pad for connecting the light emitting element LD to the transistor TR may be unnecessary to increase in surface area of the light emitting part EP within the display area. In addition, because there is no need for the space for disposing the separate connection line or connection pad, a degree of freedom in the arrangement of the light emitting parts EP may increase, and also, the number of light emitting parts EP may increase within the same area to improve the resolution of the display device.

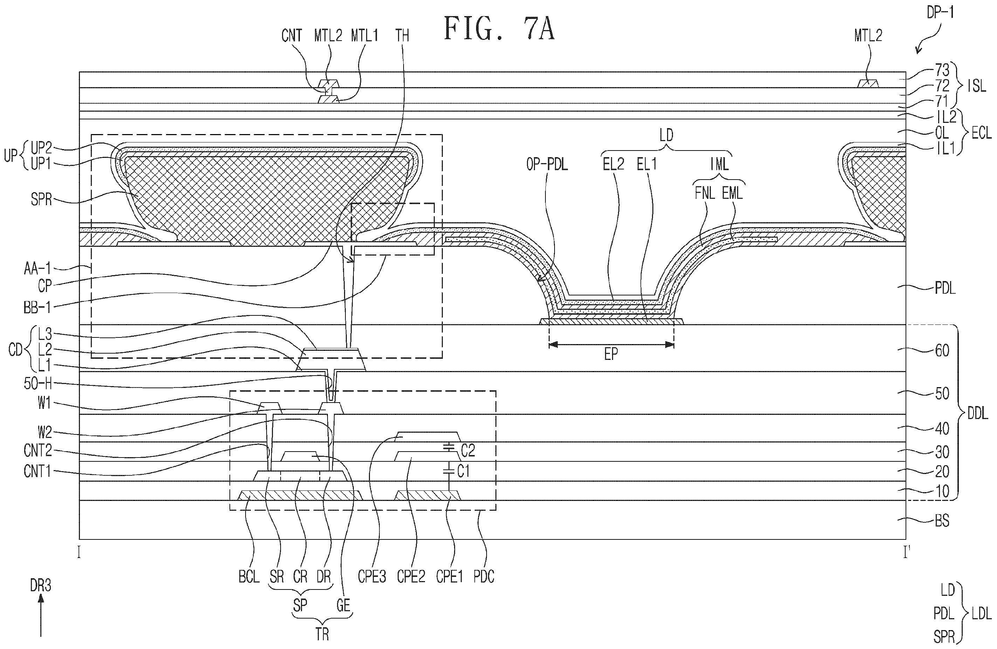

Hereinafter, a display panel will be described with reference to FIGS. 7A - 12. In descriptions of FIGS. 7A - 12, contents duplicated with those described with reference to FIGS. 1 - 6B will not be described again, and the differences will be mainly explained.

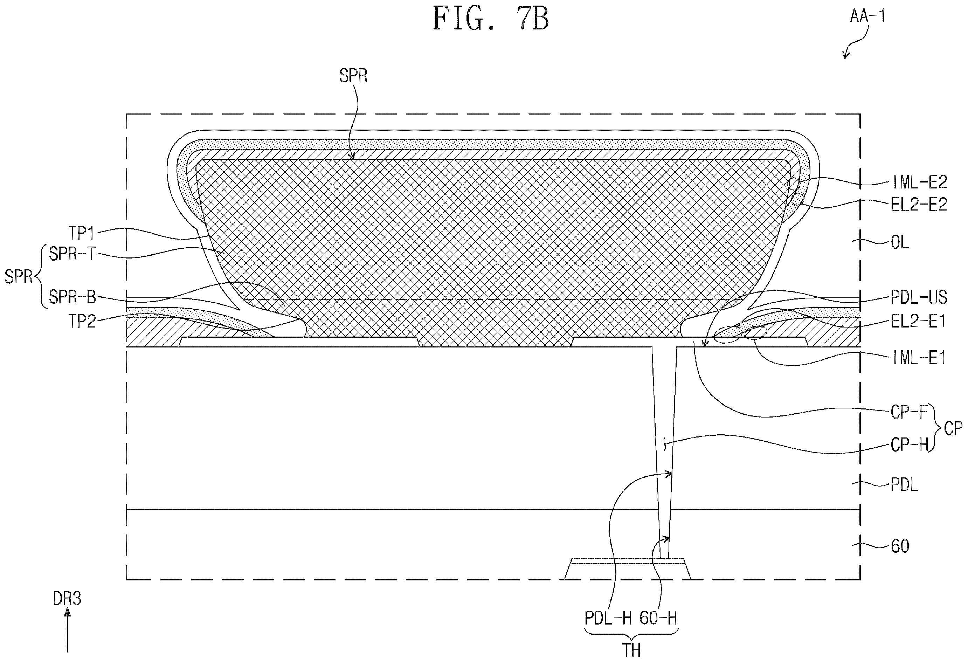

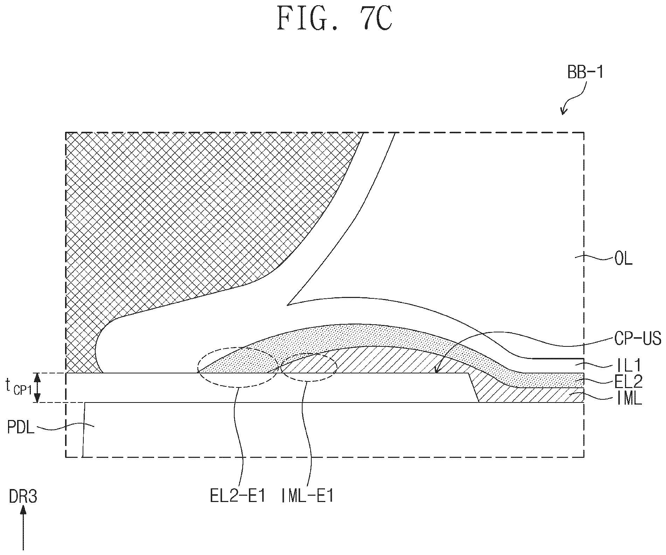

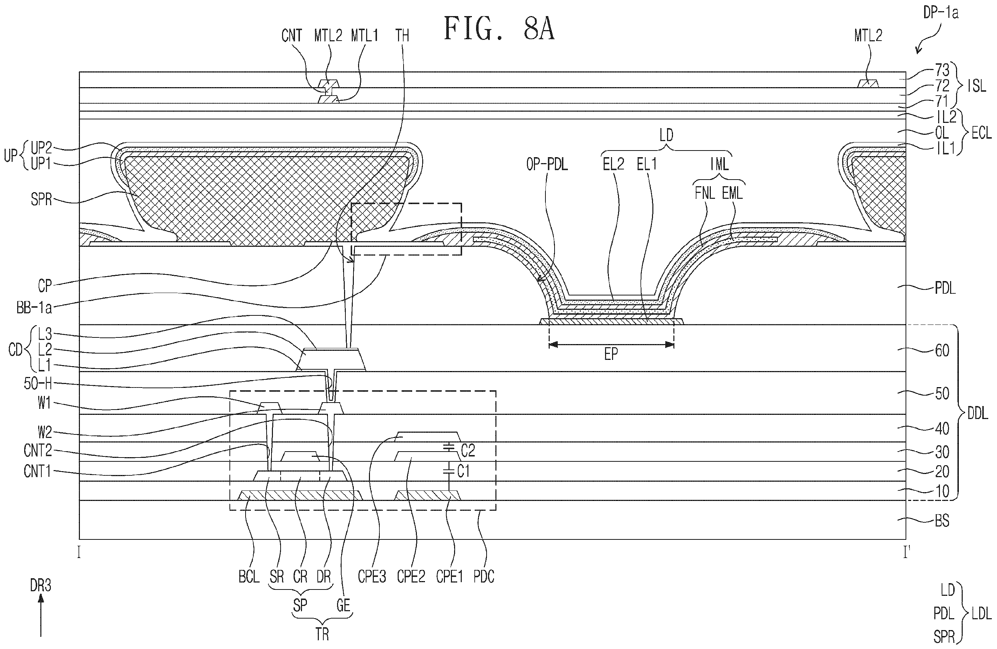

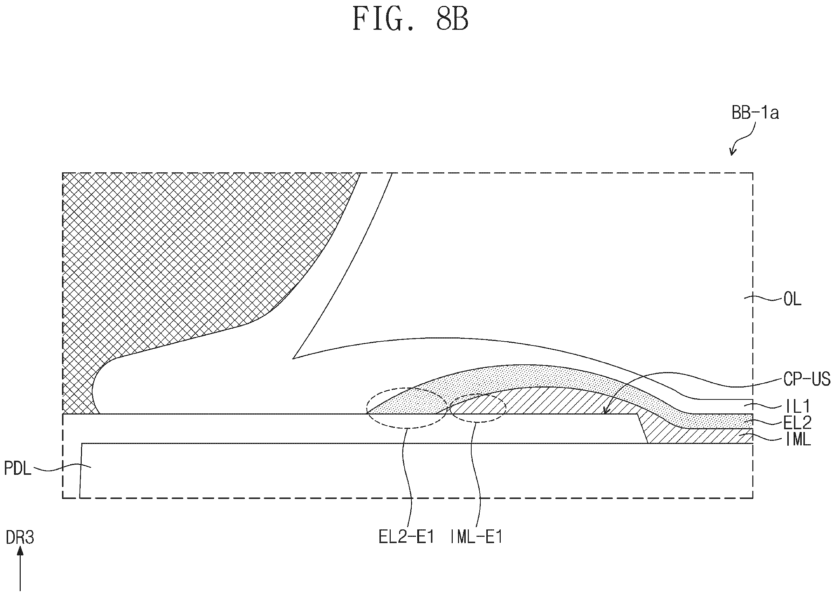

FIG. 7A is a cross-sectional view of a display panel. FIG. 7B is an enlarged cross-sectional view illustrating a partial area of the display panel. FIG. 7C is an enlarged cross-sectional view illustrating a partial area of the display panel. FIG. 7A illustrates a cross-sectional view of a portion corresponding to that in FIG. 5A, taken along the line I-I' of FIG. 4B. FIG. 7B illustrates an enlarged cross-sectional view of an area AA-1 of FIG. 7A, and FIG. 7C illustrates an enlarged cross-sectional view of an area BB-1 of FIG. 7A. FIG. 8A is a cross-sectional view of a display panel. FIG. 8B is an enlarged cross-sectional view illustrating a partial area of the display panel. FIG. 8A illustrates a cross-sectional view of a portion corresponding to that in FIG. 5A, taken along the line I-I' of FIG. 4B. FIG. 8B illustrates an enlarged cross-sectional view of an area BB-1a of FIG. 8A.

Hereinafter, display panels DP-1 and DP-1a illustrated in FIGS. 7A - 8B may be the same as the display panels DP and DP-a illustrated in FIGS. 5A - 6B except for a connection shape of a conductive pattern CP and a second electrode EL2 (hereinafter referred to as a cathode).

As described with reference to FIGS. 5A - 6B, etc., in the display panels DP-1 and DP-1a illustrated in FIGS. 7A and 8A, a pixel driver PDC and a light emitting element LD may be electrically connected by a conductive pattern CP. A cathode EL2 of the light emitting element LD may be connected to the conductive pattern CP, and thus, the cathode EL2 may be electrically connected to a transistor TR through the conductive pattern CP.

The contact part CP-H may be a portion of the conductive pattern CP that is connected to the pixel driver PDC and may be a portion that is substantially connected to the connection transistor TR. The contact part CP-H of the conductive pattern CP may pass through the pixel defining layer PDL and the sixth insulating layer 60 so as to be connected to a drain region DR of the semiconductor pattern SP through the driving connection part CD and a drain electrode pattern W2.

The extension part CP-F of the conductive pattern CP may be a portion connected to the light emitting element LD. The extension part CP-F may be a portion disposed on the top surface of the pixel defining layer PDL. The extension part CP-F may be disposed below the separator SPR. The conductive pattern CP may include an exposed portion that is not covered by the separator SPR. The second electrode EL2 may be connected to the exposed conductive pattern extension part CP-F. That is, the second electrode EL2 of the light emitting element LD may be directly contacted to an exposed end of the conductive pattern extension CP-F.

Referring to FIGS. 7A to 8B, the contact part CP-H may be disposed to be filled into the through-hole TH, and the extension part CP-F may extend from the contact part CP-H and may be disposed on the pixel defining layer PDL. The through-hole TH may entirely overlap the separator SPR. Thus, the contact part CP-H may be disposed to overlap the separator SPR.

Referring to FIGS. 7A to 8B, the cathode EL2 may be connected to exposed one end of the conductive pattern CP. The cathode EL2 may be connected to one exposed top surface CP-US of the conductive pattern CP. That is, the cathode EL2 of the light emitting element LD may be connected to the top surface CP-US of one side of the conductive pattern CP in the form of bottom contact. In addition, an edge of the cathode EL2 may be disposed closer to the through-hole TH than an edge of a functional layer FNL included in an intermediate layer IML.

A thickness t_{CP1} of the conductive pattern CP may be about 500 A (50nm) or less. That is, a thickness t_{CP1} of the extension part CP-F of the conductive pattern CP may be about 500 A (50nm) or less. The thickness t_{CP1} of the extension part CP-F may correspond to an average thickness reflecting a rough surface. As the conductive pattern CP is provided to have a thickness of about 500 A (50nm) or less, a sufficient bottom contact area of the cathode EL2 may be secured to ensure good electrical connection quality of the cathode EL2. That is, the thickness of the conductive pattern CP may be provided to be about 500 A (50nm) or less, and thus a height difference caused by the conductive pattern CP may be reduced or minimized, and the intermediate layer IML and cathode EL2 extend onto the conductive pattern CP may be easily disposed. In addition, the thickness t_{CP1} of the conductive pattern CP may be greater than or equal to a sufficient thickness for electrical connection between the cathode EL2 and the driving connection part CD. For example, the thickness t_{CP1} of the conductive pattern CP may be about 30 Å (3nm) or more, but the present disclosure is not limited thereto.

Even in an example illustrated in FIGS. 7A - 8B, the separator SPR may have a double inverted taper shape. As described with reference to FIG. 5B, etc., a taper angle defined by a first side surface TP1 and a second side surface TP2 of the separator SPR with respect to a top surface of the pixel defining layer PDL may be different from each other. In addition, the first side surface TP1 and the second side surface TP2 may be provided to have different curvatures. An inflection portion may be included between the first side surface TP1 and the second side surface TP2. The shape of each of the first side surface TP1 and the second side surface TP2 are not limited thereto, and the taper angle or curvature of each of the first side surface TP1 and the second side surface TP2 may be modified in various manners.

As shown in FIG. 7B, the separator SPR may include a lower pattern SPR-B adjacent to the pixel defining layer PDL and an upper pattern SPR-T disposed on the lower pattern SPR-B. The upper pattern SPR-T may be continuously disposed on the lower pattern SPR-B. The upper pattern SPR-T and the lower pattern SPR-B may be integrated with each other. Here, side surfaces of the lower pattern SPR-B and the upper pattern SPR-T may be provided to have different curvatures. For example, at least one inflection portion may be included between the lower pattern SPR-B and the upper pattern SPR-T. The upper pattern SPR-T may have a cross-section of which a width gradually increases in the thickness direction (e.g., the third direction DR3), and a side surface of the upper pattern SPR-T may represent a continuous curved surface. Unlike the upper pattern SPR-T, the lower pattern SPR-B may decrease in width from the pixel defining layer PDL to the upper pattern SPR-T, or may barely change in width in substantially the thickness direction (e.g., the third direction DR3). That is, the lower pattern SPR-B and the upper pattern SPR-T may include sides surface having different curvatures.

However, the shape of the separator SPR illustrated in FIGS. 7A - 8B is illustrated as an example, and if the separator SPR electrically disconnects the cathode EL2 for each pixel, the separator SPR may have various shapes.

Referring to FIGS. 7A - 8B, a portion of an extension part CP-F of the conductive pattern CP provided to a small thickness so that the cathode EL2 is sufficiently connected may include a portion that is not covered by the cathode EL2 and the separator SPR. A portion of the exposed extension part CP-F of the conductive pattern CP may be covered by a first inorganic layer IL1 of an encapsulation layer ECL.

The intermediate layer IML may be connected to a top surface CP-US of the conductive pattern CP that is exposed and not covered by the separator SPR. The cathode EL2 may be disposed on the intermediate layer IML connected to the conductive pattern CP while being connected to one top surface CP-US of the conductive pattern CP. The cathode EL2 may be disposed while covering the intermediate layer IML. The intermediate layer IML may be disposed adjacent to the light emitting part EP and may be directly connected to the top surface CP-US of the conductive pattern CP exposed to a lower side of the separator SPR, and the cathode EL2 may cover the intermediate layer IML to extend beyond the intermediate layer IML so that one end thereof is directly connected to the top surface CP-US of the conductive pattern CP.

The intermediate layer IML connected to one top surface CP-US of the conductive pattern CP may be a functional layer FNL. The cathode EL2, the exposed top surface of the conductive pattern CP, and the separator SPR may be covered by the encapsulation layer ECL.

Referring to FIGS. 7A to 8B, the cathode EL2 and the intermediate layer IML constituting the light emitting element LD may be disconnected by the separator SPR. A first end IML-E1 of the disconnected intermediate layer IML may be connected to the top surface CP-US of one end of the conductive pattern CP on the pixel defining layer PDL, and the first end IML-E1 and the second end IML-E2 (see FIG. 7B) of the disconnected intermediate layer IML may be disposed on the separator SPR.

In addition, the first end EL2-E1 of the disconnected cathode EL2 may be connected to the top surface CP-US of one end of the conductive pattern CP on the first end IML-E1 of the intermediate layer IML, and the first end EL2-E1 and the second end EL2-E2 of the disconnected cathode EL2 may be disposed on the separator SPR. The second end EL2-E2 of the cathode EL2 may cover the second end IML-E2 of the intermediate layer IML (see FIG. 7B).

A portion of the cathode EL2 and a portion of the intermediate layer IML that are disconnected and disposed above the separator SPR may be referred to as a dummy layer UP (see FIGS. 7A and 8A). As described with reference to FIGS. 5A and 5B, a portion of the disconnected cathode EL2 and a portion of the intermediate layer IML disposed on the upper portion of the separator SPR may be formed at the same time while forming the cathode EL2 and the intermediate layer IML of each of the light emitting parts. In addition, the display panel DP may not include the dummy layer UP.

Referring to FIGS. 7A to 8B, the first ends EL2-E1 and IML-E1 of the cathode EL2 and the intermediate layer IML may be spaced (e.g., spaced apart) from the separator SPR and disposed on the conductive pattern CP, and the second ends EL2-E2 and IML-E2 (see FIG. 7B) of the cathode EL2 and the intermediate layer IML may be separated from the first ends EL2-E1 and IML-E1 and may be disposed on the side surface of the separator SPR. Even if the first ends EL2-E1 and IML-E1 and the second ends EL2-E2 and IML-E2 are connected without being distinguished from each other, when a thickness of the portion disposed along the side surface of the separator SPR is thin so that electrical resistance is high, if the cathode EL2 between the adjacent pixels is electrically disconnected, it is assumed that the cathode EL2 is divided by the separator SPR.

In the display panel DP-1 illustrated in FIGS. 7A - 7C, the first end IML-E1 of the disconnected intermediate layer IML and the first end EL2-E1 of the cathode EL2 may overlap the separator SPR on the plane (e.g., in a plan view). That is, a first end IML-E1 of the disconnected intermediate layer IML and a first end EL2-E1 of the cathode EL2, which are connected in the form of bottom contact, on one top surface CP-US of the conductive pattern CP may be disposed below the separator SPR to overlap the separator SPR on the plane (e.g., in a plan view).

A display panel DP-1a illustrated in FIGS. 8A and 8B may be the same as the display panel DP-1 illustrated in FIGS. 7A - 7C except for a connection position of a conductive pattern CP and a second electrode EL2 (hereinafter referred to as a cathode).

In the display panel DP-1a illustrated in FIGS. 8A and 8B , the first end IML-E1 of the disconnected intermediate layer IML and the first end EL2-E1 of the cathode EL2 may not overlap the separator SPR on the plane (e.g., in a plan view). That is, one edge of the extension part CP-F of the conductive pattern CP may extend so as not to overlap the separator SPR, a first end IML-E1 of the disconnected intermediate layer IML and a first end EL2-E1 of the cathode EL2, which are connected in the form of bottom contact, on one top surface CP-US of the conductive pattern CP may be spaced (e.g., spaced apart) from the separator SPR so as not to overlap the separator SPR on the plane (e.g., in a plan view).

A display device including display panels DP-1 and DP-1a described with reference to FIGS. 7A - 8B may include the conductive pattern CP disposed below the separator SPR, and the conductive pattern CP may be directly connected to each of the cathode EL2 and the driving connection part CD, and thus, the separate connection line and/or connection pad for connecting the light emitting element LD to the transistor TR may not be required to increase in surface area of the light emitting part EP within the display area. In addition, because there is no need for the space for disposing the separate connection line or connection pad, a degree of freedom in the arrangement of the light emitting parts EP may increase, and also, the number of light emitting parts EP may increase within the same area to improve the resolution of the display device.

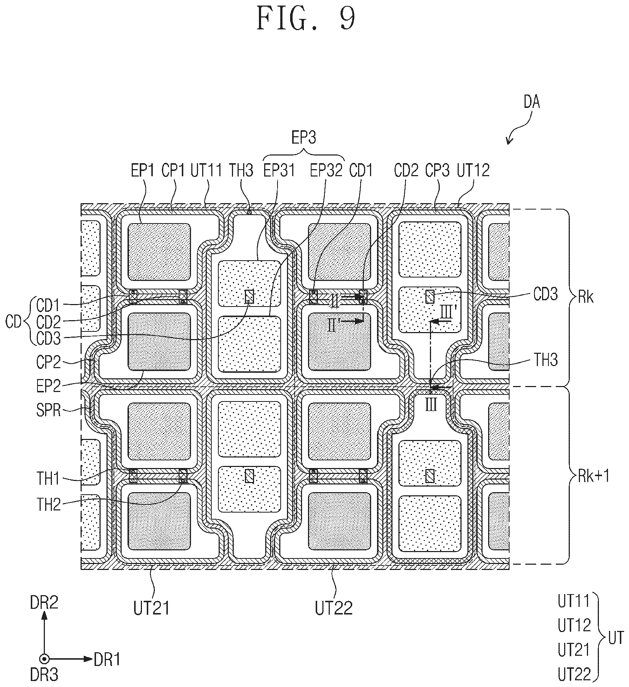

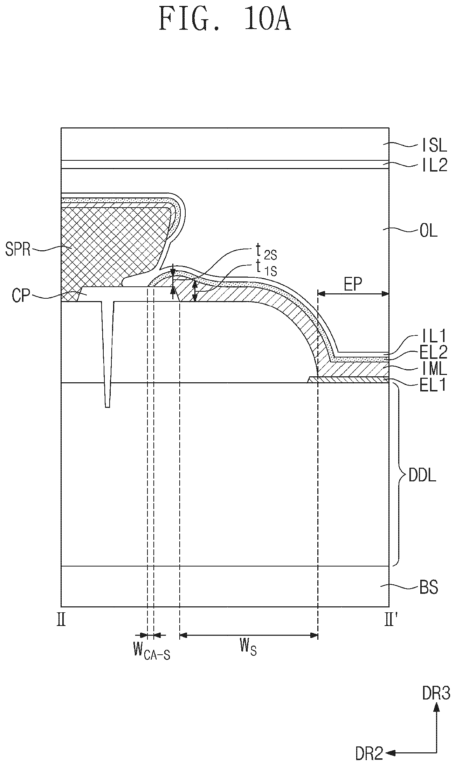

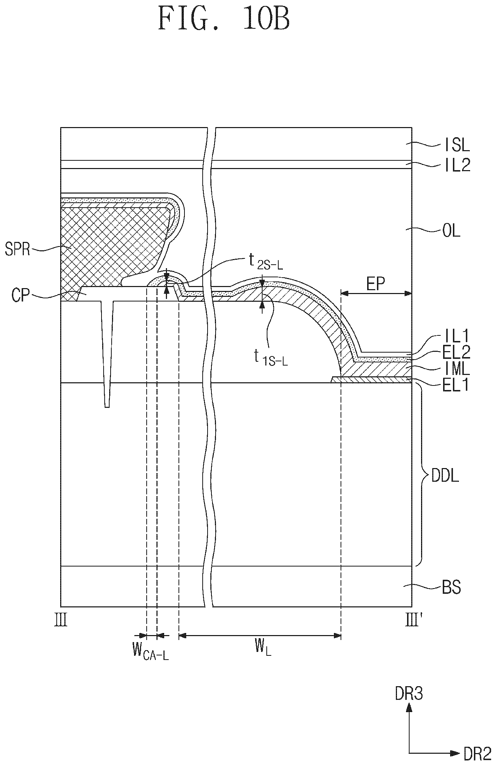

FIG. 9 is an enlarged plan view illustrating a partial area of the display panel. FIGS. 10A and 10B are an enlarged cross-sectional view illustrating a partial area of the display panel. FIG. 10A illustrates a cross-sectional view of a portion corresponding to the line II-II' of FIG. 9, and FIG. 10B illustrates a cross-sectional view of a portion corresponding to the line III-III' of FIG. 9. FIG. 9 is a plan view corresponding to that of FIG. 4A. Thus, the contents of each configuration described with reference to FIGS. 4A - 4C may be equally applied to FIG. 9.

FIG. 9 illustrates an area on which a total of four light emitting units UT (UT11, UT12, UT21, UT22) are disposed in two rows and two columns, like in FIG. 4A. In FIG. 9, a distance between the third light emitting parts EP3 (e.g., EP31 and EP32) included in different light emitting units spaced (e.g., spaced apart) in the second direction DR2 may be greater than that between the first light emitting part EP1 and the second light emitting part EP2, which are spaced (e.g., spaced apart) from each other in the second direction DR2.

FIG. 10A illustrates a separator SPR disposed between the first and second light emitting parts EP1 and EP2 and a portion of the light emitting part EP adjacent to the separator SPR, and FIG. 10B illustrates a separator SPR disposed between the third light emitting parts EP3 included in the light emitting units different from each other and a light emitting part EP adjacent to the separator SPR. In FIGS. 10A and 10B, components such as the driving element layer DDL are omitted. As illustrated in FIGS. 10A and 10B, the configuration of the driving element layer DDL may be applied in the same manner as illustrated in FIG. 5A.

Referring to FIGS. 10A and 10B, as distances (e.g., spaced distances) Ws and W_{L} between the conductive patterns CP disposed below the separator SPR from the light emitting part EP increases, thicknesses t_{2S} and t_{2S-L} of the intermediate layers IML disposed adjacent to the conductive pattern CP may become thinner. Thus, widths W_{CA-S} and W_{CA-L} of the cathode EL2 directly connected to the conductive pattern CP may increase, and connection quality of the cathode EL2 may be improved.

The distance W_{L} between the light emitting part EP and the conductive pattern CP illustrated in FIG. 10B is greater than the distance Ws between the light emitting part EP and the conductive pattern CP illustrated in FIG. 10A. Thus, in the case of the portion illustrated in FIG. 10A, in the thickness of the intermediate layer IML, a difference between a thickness tis adjacent to the light emitting part EP and a thickness tzs of the portion spaced from the light emitting part EP and connected to the conductive pattern CP may not be large. However, in the case of the portion illustrated in FIG. 10B, in the thickness of the intermediate layer IML, a thickness t_{2S-L} of a portion spaced from the light emitting portion EP and connected to the conductive pattern CP may be significantly reduced compared to the thickness t_{1S-L} adjacent to the light emitting part EP. Thus, in the case illustrated in FIG. 10B, it may be easier to provide the cathode EL2 to cover the intermediate layer IML below the separator SPR than in the case illustrated in FIG. 10A. Thus, a connection width W_{CA-L} of the cathode EL2 illustrated in FIG. 10B may be greater than a connection width W_{CA-S} of the cathode EL2 illustrated in FIG. 10A. That is, a connection area of the cathode EL2 illustrated in FIG. 10B may be greater than a connection area of the cathode EL2 illustrated in FIG. 10A. Thus, as the spaced distance between the neighboring light emitting parts increases, the surface area of the cathode EL2 connected to the top surface of the conductive pattern CP may increase.

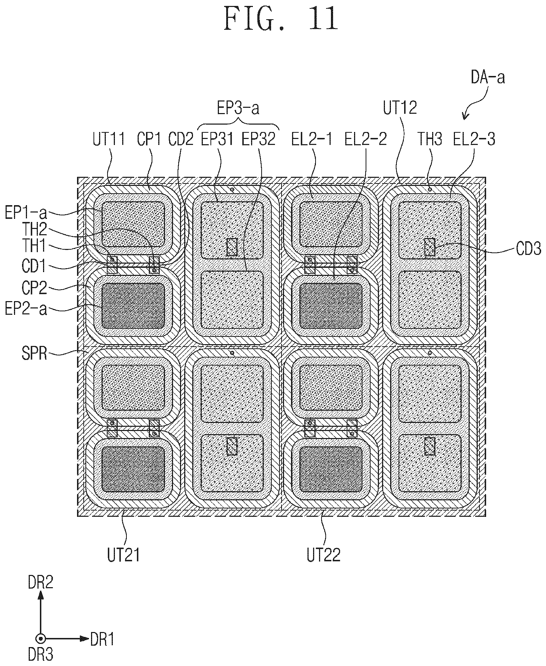

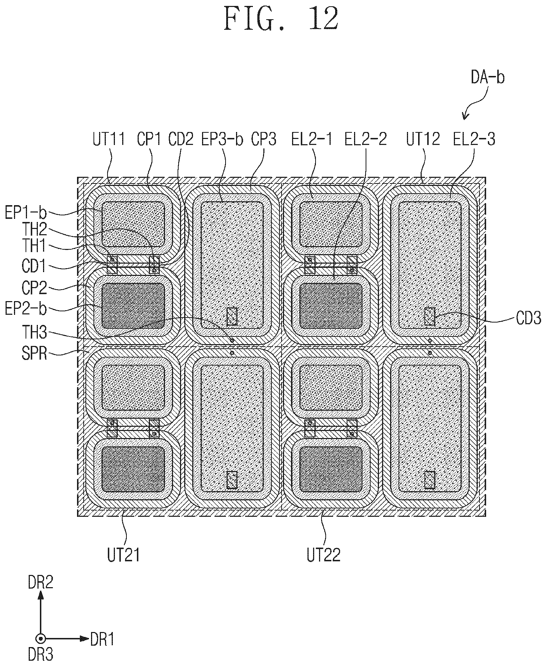

FIGS. 11 and 12 are plan views illustrating a partial area of the display panel. FIGS. 11 and 12 are plan views illustrating a portion corresponding to that of FIG. 4A. FIGS. 11 and 12 illustrate portions of display areas DA-a and DA-b as the portions corresponding to that of FIG. 4A

FIGS. 11 and 12 illustrate light emitting units UT11, UT12, UT21, and UT22 in two rows and two columns. The light emitting parts in a first row Rk include the light emitting parts constituting a first row first column light emitting unit UT11 and a first row second column light emitting unit UT12, and the light emitting parts in a second row Rk+1 include the light emitting parts constituting a second row first column light emitting unit UT21 and a second row second column light emitting unit UT22. The example illustrated in FIGS. 11 and 12 is different from the example described with reference to FIG. 4A in a shape of a light emitting unit including light emitting parts and a shape of a separator. Thus, in the case of the example illustrated in FIGS. 11 and 12, the content described with reference to FIGS. 1 - 10B may be applied equally except for the shapes of the light emitting unit and the separator.

Referring to FIGS. 11 and 12, each of the light emitting units UT11, UT12, UT21, and UT22 may include first light emitting parts EP1-a and EP1-b, second light emitting parts EP2-a and EP2-b, and third light emitting parts EP3-a and EP3-b.

The first light emitting parts EP1-a and EP1-b, the second light emitting parts EP2-a and EP2-b, and the third light emitting parts EP3-a and EP3-b may emit light having colors different from each other. For example, the first light emitting parts EP1-a and EP1-b may emit red light, the second light emitting parts EP2-a and EP2-b may emit green light, and the third light emitting parts EP3-a and EP3-b may emit blue light, but the combination of the colors is not limited thereto. In addition, at least two or more of the light emitting parts may emit light having the same color. For example, all of the first to third light emitting parts may emit blue light or emit white light.

In the example illustrated in FIG. 11, a third light emitting part EP3-a may include two sub light emitting parts EP31 and EP32 spaced (e.g., spaced apart) from each other in the second direction DR2. In addition, in the case of the example illustrated in FIG. 12, a third light emitting part EP3-b may be provided as one area and may have a surface area greater than that of each of the first light emitting part EP1-b and the second light emitting part EP2-b.

As illustrated in FIGS. 11 and 12, each of the first light emitting parts EP1-a and EP1-b, the second light emitting parts EP2-a and EP2-b, and the third light emitting parts EP3-a and EP3-b may have a rectangular shape provided with curved corners when viewed on the plane (e.g., in a plan view). In addition, when compared to the shapes of the light emitting units illustrated in FIG. 4A, etc., each of the light emitting units may include light emitting parts and may be divided into a rectangular shape according to the shape of each of the light emitting parts.

As illustrated in FIGS. 11 and 12, the separator SPR may be provided along the shape of the light emitting part to be around (e.g., to surround) the light emitting part. Conductive patterns CP1, CP2, CP3 connecting driving connection parts CD1, CD2, and CD3 and the light emitting parts may be provided to overlap a separator SPR, and through-hole TH1, TH2, and TH3 in which some of the conductive patterns CP1, CP2, and CP3 are disposed may be disposed to overlap the separator SPR. As described with reference to FIGS. 4A - 8B, the conductive patterns CP1, CP2, and CP3 disposed in the through-holes TH1, TH2, and TH3 and the driving connection parts CD1, CD2, and CD3 may be connected to each other, and some of the conductive patterns CP1, CP2, and CP3 disposed to overlap the separator SPR may be connected to the cathode EL2 (FIG. 5A) of the light emitting element LD (see FIG. 5A). That is, even in the example illustrated in FIGS. 11 and 12, a connection line or connection pad for connecting a pixel driver to a light emitting element may be excluded, and the light emitting parts EP3-a and EP3-b may be disposed to be expanded to the portion for arranging the connection line or connection pad. In addition, the separator SPR and conductive patterns CP1, CP2, and CP3 may be provided according to the shape of the light emitting part without considering a space for arranging the connection line or connection pad, and thus, the light emitting parts may be arranged in a larger number within the same area. That is, when compared to the arrangement of the light emitting parts illustrated in FIG. 4A, etc., in the display areas DA-a and DA-b of FIGS. 11 and 12, a surface area of the portion on which the light emitting parts are not arranged within one light emitting unit may be reduced. Thus, the display device according to one or more embodiments may implement high resolution.

The display device according to one or more embodiments may include the conductive pattern connecting the cathode of the light emitting element to the pixel driver, and the conductive pattern may be disposed to overlap the separator to reduce or minimize the surface area for the arrangement of the conductive pattern and also electrically easily connect the light emitting element to the pixel driver. In the display device according to one or more embodiments, the through-hole in which the conductive pattern for the electrical connection between the light emitting element and the pixel driver is disposed may be provided to overlap the separator, and thus, the separate connection line and connection pad for connecting the light emitting element to the pixel driver may be omitted, and as the arrangement area of the light emitting part increases, and the degree of freedom in arranging the light emitting part increases, the improved resolution characteristics may be exhibited.

In the display device according to one or more embodiments, the conductive pattern that connects the pixel circuit part and the light emitting element may be disposed below the separator to reduce or minimize the space for disposing the separate contact structure for connecting the light emitting element to the pixel circuit part, thereby improving the resolution characteristics.

It will be apparent to those skilled in the art that various modifications and deviations can be made in the present disclosure. Thus, it is intended that the present disclosure covers the modifications and deviations of the present disclosure provided they come within the scope of the appended claims.

Accordingly, the technical scope of the present disclosure should not be limited to the contents described in the detailed description of the specification, but should be determined by the claims.

## Claims

1. A display device comprising:
a base layer (BS);
a driving element layer (DDL) on the base layer and comprising a transistor (TR), a plurality of insulating layers (10, 20, 30, 40 50, 60) on the transistor, and a driving connection part (CD) electrically connected to the transistor;
a light emitting element layer (LDL) on the driving element layer and comprising a pixel defining layer (PDL), in which a light emitting opening (OP-PDL) and a through-hole (PDL-H) that does not overlap the light emitting opening are defined, a light emitting element (LD) located in the light emitting opening, and a separator (SPR) located on the pixel defining layer; and
a conductive pattern (CP) located below the separator and comprising a contact part (CP-H) in the through-hole, and an extension part (CP-F) connected to the contact part and located on a top surface of the pixel defining layer,
wherein the light emitting element (LD) comprises an anode (EL1) on the driving element layer, an intermediate layer (IML) on the anode, and a cathode (EL2) on the intermediate layer, and
wherein the contact part (CP-H) is electrically connected to the driving connection part (CD), and the extension part (CP-F) is connected to the cathode (EL2) on the top surface of the pixel defining layer.

2. The display device of claim 1, wherein, in a plan view, the through-hole is spaced from an edge of the separator and overlaps the separator.

3. The display device of claim 1 or 2, wherein one side surface of the extension part adjacent to the light emitting opening on the pixel defining layer is exposed from the separator, and
wherein the cathode is connected to the exposed one side surface of the extension part.

4. The display device of claim 3, wherein the cathode and the intermediate layer are disconnected by the separator, and
wherein a first end of the disconnected intermediate layer is connected to the one side surface on the pixel defining layer, and a first end of the disconnected cathode is connected to the one side surface on the intermediate layer.

5. The display device of claim 4, wherein the first end of the intermediate layer and the first end of the cathode do not overlap the separator in a plan view, or the first end of the intermediate layer and the first end of the cathode overlap the separator in a plan view.

6. The display device of claim 4, wherein a second end of the disconnected intermediate layer is on the separator, and
wherein a second end of the disconnected cathode is located on the intermediate layer on the separator.

7. The display device of any one of claims 3 to 6, wherein the extension part has a thickness of about 1,000 Å (100nm) or more and about 5,000 Å (500nm) or less.

8. The display device of claim 1, wherein one end of the extension part adjacent to the light emitting opening on the pixel defining layer is exposed from the separator, and
wherein the cathode is connected to an exposed top surface of the one end of the extension part.

9. The display device of claim 8, wherein the cathode and the intermediate layer are disconnected by the separator,
wherein a first end of the disconnected intermediate layer is directly located on the exposed top surface, and
wherein a first end of the disconnected cathode is configured to cover the intermediate layer on the exposed top surface and is contacted to the exposed top surface.

10. The display device of claim 9, wherein the first end of the intermediate layer and the first end of the cathode overlap the separator in a plan view, or the first end of the intermediate layer and the first end of the cathode do not overlap the separator in a plan view.

11. The display device of claim 9 or 10, wherein a second end of the disconnected intermediate layer is on the separator, and
wherein a second end of the disconnected cathode is on the intermediate layer on the separator.

12. The display device of any one of claims 8 to 11, wherein the extension part has a thickness of about 500 Å (50nm) or less.

13. The display device of any one of the preceding claims, wherein the separator comprises:
a lower pattern adjacent to the pixel defining layer; and
an upper pattern continuously located on the lower pattern and having a width greater than that of the lower pattern in a cross-section,
wherein, in the cross-section, a side surface of the separator comprises an inflection portion between the lower pattern and the upper pattern.

14. The display device of claim 1, wherein the driving connection part comprises a first layer comprising titanium, a second layer on the first layer and comprising aluminum, and a third layer on the second layer and comprising titanium, which are sequentially laminated.

15. The display device of claim 1, wherein the transistor comprises a semiconductor pattern including a source region, a drain region, and a channel region located between the source region and the drain region, and
wherein the conductive pattern is electrically connected to the drain region through the driving connection part.
